(19)

**Europäisches Patentamt**
**European Patent Office**
**Office européen des brevets**

(11) **EP 4 531 115 A1**

(12) **EUROPEAN PATENT APPLICATION**

(43) Date of publication:
**02.04.2025 Bulletin 2025/14**

(51) International Patent Classification (IPC):
**H01L 31/0232** *(2014.01)*    *G02B 6/12* *(2006.01)*
*G02F 1/025* *(2006.01)*    *G02F 1/035* *(2006.01)*

(21) Application number: **23200214.7**

(22) Date of filing: **27.09.2023**

(52) Cooperative Patent Classification (CPC):
**H10F 77/407;** G02B 2006/121; G02B 2006/12142;
G02F 1/025; G02F 1/035

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Black Semiconductor GmbH**
**52072 Aachen (DE)**

(72) Inventor: **HUYGHEBAERT, Cedric**
**52072 Aachen (DE)**

(74) Representative: **Herzog IP Patentanwalts GmbH**
**Steinstraße 16-18**
**40212 Düsseldorf (DE)**

(54) **OPTO-ELECTRONIC COMPONENT WITH AN ELECTRICAL VIA CONNECTING TO AN ELECTRICAL CONDUCTOR LAYER THROUGH TWO DIELECTRIC LAYERS**

(57)    The invention pertains to a component (100), comprising:
a. a dielectric layer A (103),
b. a dielectric layer B (104), and
c. an optical element layer (105);
wherein the layer sequence further comprises a first electrical conductor layer (108); wherein at least a first region (110) of the first electrical conductor layer (108) and at least a first region (111) of the optical element layer (105) overlap one another; wherein a first electrical connection (113) extends through the dielectric layer A (103) and at least partially through the dielectric layer B (104) and electrically connects to the first electrical conductor layer (108); wherein the dielectric layer A (103) is less resistant to a first etching method than the dielectric layer B (104), and the dielectric layer B (104) is less resistant to a further etching method than the dielectric layer A (103). The invention further pertains to a method (700), to an electronic device (1500) and to uses of the component (100).

Figure 2

100

EP 4 531 115 A1

**Description**

FIELD OF THE INVENTION

The invention pertains to a component, comprising a layer sequence, including at least the following layers superimposed on one another in the given order from a first side of the component to a further side of the component, which is opposite to the first side:

 a. a dielectric layer A,
 b. a dielectric layer B, and
 c. an optical element layer;

wherein the layer sequence further comprises a first electrical conductor layer; wherein, in a view in a first direction, which runs from the first side to the further side, at least a first region of the first electrical conductor layer and at least a first region of the optical element layer overlap one another; wherein a first layer surface of the dielectric layer A faces away from the dielectric layer B; wherein a first electrical connection extends from the first layer surface of the dielectric layer A through the dielectric layer A and at least partially through the dielectric layer B and electrically connects to the first electrical conductor layer; wherein the dielectric layer A is less resistant to a first etching method than the dielectric layer B, and the dielectric layer B is less resistant to a further etching method than the dielectric layer A. The invention further pertains to a method, to an electronic device and to uses of the component.

BACKGROUND

Opto-electronic devices such as modulators and photodetectors are important electronic components for optical communication systems, e.g., data transmission via fibre optics. Some of the important parameters for these devices are bandwidth, operation speed, extinction ratio, insertion loss, energy consumption, responsivity and footprint. One option is silicon-based modulators. However, silicon-based modulators have a number of disadvantages. For example, silicon-based modulators have a narrow bandwidth. Furthermore, in order to integrate a silicon-based modulator with other electronic components, such as CMOS integrated circuits, silicon-based modulators have to be produced as part of a front-end-of-line process. In addition, silicon-based modulators cannot easily be integrated with newer technologies that are being developed in the electronic industry. This is in contrast to graphene-based modulators, which have a number of advantages. For example, graphene-based modulators have a broader bandwidth compared to silicon-based modulators. Furthermore, graphene-based modulators can be integrated with other electronic components as part of a back-end-of-line process, without requiring significant development to enable the integration. Graphene-based modulators can also be more easily integrated with newer technologies in the electronic industry. Graphene-based modulators further allow for a better use of surface area, and thus a more compact electronic device or system.
Producing graphene-based opto-electronic devices remains challenging, in particular, because a graphene sheet with a thickness of a single atomic layer is very delicate. In the prior art, a photolithographic method which involves a sacrificial photosensitive resist layer is used to form holes for vias and a metal lift-off is needed to produce the vias to electrically connect to graphene sheets. This method involves many steps, including the application of the photoresist layer which is irradiated, developed and has to be removed completely using the metal lift-off at the end of the method. If a via to contact a sheet of graphene is to be prepared, the graphene sheet is exposed once the hole for the via has been formed. This means that delicate single atomic layer material is exposed to all the subsequent steps of chemically and mechanically cleaning the hole from etchant and also of cleaning the device precursor from remainders of the photoresist. Mechanical damage which the graphene experiences in these steps and also chemical residues of these steps on the graphene will have a negative effect on the performance of the opto-electronic device. In result, in the production of graphene-based opto-electronic devices the reject rate is unfavourably high.

OBJECTS

An object of the present invention is to at least partially overcome at least one of the disadvantages encountered in the state of the art.
It is a further object of the invention to provide an electronic device, such as a computing device or a memory, with an opto-electronic component, where the design of the opto-electronic component allows to produce the electronic device at a reduced reject rate. Further, it is an object of the invention to provide an opto-electronic component, such as a detector, a modulator, a filter, an interferometer, and a bolometer, which can be produced at a reduced reject rate.
It is a further object of the invention to provide an opto-electronic component, such as a detector, a modulator, a filter, an interferometer, and a bolometer, which can be produced with a reduced width of the distribution of performance of all the opto-electronic components of this type produced on the same wafer. Further, it is an object of the invention to provide a photodetector which can be produced with a reduced width of the distribution of the responsivity of all photodetectors of this type produced on the same wafer. Further, it is an object of the invention to provide an opto-electronic modulator which can be produced with a reduced width of the distribution of the modulation speed of all modulators of this type produced on the same wafer.

Further, it is an object of the invention to provide an opto-electronic component which can encode and/or decode an increased data stream.

Further, it is an object of the invention to provide an opto-electronic component which can be produced with less process steps, using less sacrificial layers and/or from less source material.

It is a further object of the invention to provide an opto-electronic component with improved confinement of light in a waveguide and/or with reduced crosstalk.

It is a further object of the invention to provide one of the above advantageous opto-electronic components, where the component includes no additional layer, does not suffer from a reduction of integrity, has an as broad as possible bandwidth, it can be integrated with other electronic components as part of a back-end-of-line process without requiring significant development to enable the integration, it can easily integrated with state-of-the-art technology in the electronic industry, and/or it is as compact as possible.

Preferably, the above opto-electronic devices are graphene-based.

DETAILED DESCRIPTION OF THE INVENTION

A contribution to at least partly fulfilling at least one, preferably more than one, of the above-mentioned objects is made by any of the embodiments of the invention.

A 1st embodiment of the invention is a component, comprising a layer sequence, including at least the following layers superimposed on one another in the given order from a first side of the component to a further side of the component, which is opposite to the first side:

a. a dielectric layer A,
b. a dielectric layer B, and
c. an optical element layer;

wherein the layer sequence further comprises a first electrical conductor layer; wherein, in a view in a first direction, which runs from the first side to the further side, at least a first region of the first electrical conductor layer and at least a first region of the optical element layer overlap one another; wherein a first layer surface of the dielectric layer A faces away from the dielectric layer B; wherein a first electrical connection extends from the first layer surface of the dielectric layer A through the dielectric layer A and at least partially through the dielectric layer B and electrically connects to the first electrical conductor layer; wherein the dielectric layer A is less

resistant to a first etching method than the dielectric layer B, and the dielectric layer B is less resistant to a further etching method than the dielectric layer A.

The first etching method is different from the further etching method. A first layer or material is more/less resistant to a certain etching method than a second layer or material if the etch rate of this etching method is less/more for the first layer or material than for the second layer or material.

In a preferred embodiment of the component, at last one, preferably each, of the following applies:

a| a selectivity of the first etching method for the dielectric layer A over the dielectric layer B is more than 1, preferably at least 5, more preferably at least 10, more preferably at least 20, more preferably at least 30, more preferably at least 40, more preferably at least 50, more preferably at least 60, more preferably at least 70, more preferably at least 80, even more preferably at least 90, most preferably at least 100;

b| a selectivity of the first etching method for the dielectric layer B over the dielectric layer A is less than 1, preferably not more than 1/5, more preferably not more than 1/10, more preferably not more than 1/20, more preferably not more than 1/30, more preferably not more than 1/40, more preferably not more than 1/50, more preferably not more than 1/60, more preferably not more than 1/70, more preferably not more than 1/80, even more preferably not more than 1/90, most preferably not more than 1/100;

c| a selectivity of the further etching method for the dielectric layer A over the dielectric layer B is less than 1, preferably not more than 1/5, more preferably not more than 1/10, more preferably not more than 1/20, more preferably not more than 1/30, more preferably not more than 1/40, more preferably not more than 1/50, more preferably not more than 1/60, more preferably not more than 1/70, more preferably not more than 1/80, even more preferably not more than 1/90, most preferably not more than 1/100;

d| a selectivity of the further etching method for the dielectric layer B over the dielectric layer A is more than 1, preferably at least 5, more preferably at least 10, more preferably at least 20, more preferably at least 30, more preferably at least 40, more preferably at least 50, more preferably at least 60, more preferably at least 70, more preferably at least 80, even more preferably at least 90, most preferably at least 100.

This preferred embodiment is a 2nd embodiment of the invention, that preferably depends on the 1st embodiment of the invention.

Particularly preferred combinations of the above items are a| c|, a| d|, b| c|, b| d|, a| c| and a| b| c| d|.

In a preferred embodiment of the component, the first electrical conductor layer has a layer thickness of less than 1 $\mu$m, preferably less than 900 nm, more preferably less than 800 nm, more preferably less than 700 nm, more preferably less than 600 nm, more preferably less than 500 nm, more preferably less than 400 nm, more preferably less than 300 nm, more preferably less than 200 nm, more preferably less than 100 nm, more preferably less than 90 nm, more preferably less than 80 nm, more preferably less than 70 nm, more preferably less than 60 nm, more preferably less than 50 nm, more preferably less than 40 nm, more preferably less than 30 nm, more preferably less than 20 nm, more preferably less than 10 nm, more preferably less than 9 nm, more preferably less than 8 nm, more preferably less than 7 nm, more preferably less than 6 nm, more preferably less than 5 nm, more preferably less than 4 nm, more preferably less than 3 nm, more preferably less than 2 nm even more preferably less than 1 nm. This preferred embodiment is a 3rd embodiment of the invention, that preferably depends on the 1st or 2nd embodiment of the invention.

Preferably, the lower limit of the thickness of the first electrical conductor layer is the thickness of an atomic monolayer or molecular monolayer of the material of the first electrical conductor layer.

In a preferred embodiment of the component, the first electrical conductor layer consists of a number of layers of atoms or molecules; wherein the number of layers of atoms or molecules is at least 1, preferably in the range from 1 to 10, preferably from 1 to 9, more preferably from 1 to 8, more preferably from 1 to 7, more preferably from 1 to 6, more preferably from 1 to 5, more preferably from 1 to 4, more preferably from 1 to 3, even more preferably the number of layers of atoms or molecules is 1 or 2, most preferably 1. This preferred embodiment is a 4th embodiment of the invention, that preferably depends on any of the preceding embodiments of the invention.

The layers of atoms or molecules follow one another in the first direction. Preferred layers of atoms are layers of carbon atoms.

In a preferred embodiment of the component, the first electrical conductor layer superimposes the optical element layer on a side of the optical element layer which faces the first side of the component, or on a side of the optical element layer which faces the further side of the component, or both. This preferred embodiment is a 5th embodiment of the invention, that preferably depends on any of the preceding embodiments of the invention.

In a preferred embodiment of the component, the first electrical conductor layer is arranged between the dielectric layer A and the optical element layer. This preferred embodiment is a 6th embodiment of the invention, that preferably depends on any of the preceding embodiments of the invention.

In a preferred embodiment of the component, the dielectric layer A comprises, preferably consists of, an inorganic material A, or the dielectric layer B comprises, preferably consists of, an inorganic material B, or both. This preferred embodiment is a 7th embodiment of the invention, that preferably depends on any of the preceding embodiments of the invention.

The inorganic material A is different from the inorganic material B. Preferably, the dielectric layer A comprises the inorganic material A in a proportion of at least 50 wt.-%, more preferably at least 60 wt.-%, more preferably at least 70 wt.-%, more preferably at least 80 wt.-%, even more preferably at least 90 wt.-%, in each case based on the weight of the dielectric layer A. Additionally or alternatively preferred, the dielectric layer B comprises the inorganic material B in a proportion of at least 50 wt.-%, more preferably at least 60 wt.-%, more preferably at least 70 wt.-%, more preferably at least 80 wt.-%, even more preferably at least 90 wt.-%, in each case based on the weight of the dielectric layer B.

In a preferred embodiment of the component, the dielectric layer A, or the dielectric layer B, or each of both is not a photoresist. This preferred embodiment is an 8th embodiment of the invention, that preferably depends on any of the preceding embodiments of the invention.

In a preferred embodiment of the component, the dielectric layer A is also less resistant to the first etching method than a photo resist. This preferred embodiment is a 9th embodiment of the invention, that preferably depends on any of the preceding embodiments of the invention.

In a preferred embodiment of the component, the photoresist is a positive photoresist or a negative photoresist. This preferred embodiment is a 10th embodiment of the invention, that preferably depends on the 9th embodiment of the invention.

In a preferred embodiment of the component, the photoresist is one selected from the group consisting of a photopolymeric photoresist, a photodecomposing photoresist, a photocrosslinking photoresist, and a self-assembled monolayer photoresist, or a combination of at least two thereof. This preferred embodiment is an 11th embodiment of the invention, that preferably depends on the 9th or 10th embodiment of the invention.

In a preferred embodiment of the component, the photoresist is one selected from the group consisting of a methyl methacrylate, a poly(phthalaldehyde), a photo acid generator (PAG), an azide quinone, novolac resin, epoxy-based resist, an off-stoichiometry thiol-enes(OSTE) polymer, a hydrogen silsesquioxane (HSQ), and benzocyclobutene (BCB), or a combination of at least two thereof. This preferred embodiment is a 12th embodiment of the invention, that preferably depends on any of the 9th to 11th embodiments of the invention.

A preferred azide quinone is diazonaphthaquinone (DNQ), A preferred epoxy-based resist is SU-8 photoresist.

In a preferred embodiment of the component, the first etching method, or the further etching method, or each of both is a dry etching method, or a wet etching method, or a combination of both. This preferred embodiment is a 13th embodiment of the invention, that preferably depends on any of the preceding embodiments of the invention.

A preferred dry etching method is one selected from the group consisting of atomic layer etching, plasma etching, and reactive ion etching, or a combination of at least two thereof. A preferred wet etching method is atomic layer etching or makes use of at least one selected from the group consisting of hydrofluoric acid, buffered hydrofluoric acid, buffered oxide etch, ammonium fluoride, phosphoric acid, hydrochloric acid, and hydrogen peroxide, or of a combination of at least two thereof, in each case as etchant.

A particularly preferred further etching method is atomic layer etching. Here, atomic layer etching may be performed dry or wet.

In a preferred embodiment of the component, the first etching method uses a first etchant and the further etching method uses a further etchant, wherein the first etchant is different from the further etchant. This preferred embodiment is a 14th embodiment of the invention, that preferably depends on any of the preceding embodiments of the invention.

In a preferred embodiment of the component, the first etchant is one selected from the group consisting of a fluoride, Ar, N, He, H, and a bromide, or a combination of at least two thereof. This preferred embodiment is a 15th embodiment of the invention, that preferably depends on the 14th embodiment of the invention.

In a preferred embodiment of the component, the further etchant is one selected from the group consisting of a fluoride, a chloride, Ar, N, He, and H, or a combination of at least two thereof. This preferred embodiment is a 16th embodiment of the invention, that preferably depends on the 14th or 15th embodiment of the invention.

In a preferred embodiment of the component, the inorganic material A, or the inorganic material B, or each of both is an oxide, or a nitride, or both. This preferred embodiment is a 17th embodiment of the invention, that preferably depends on any of the 7th or 16th embodiments of the invention.

In this context, one selected from the group consisting of silicon dioxide, an aluminium oxide, zirconium dioxide, hafnium oxide, titanium dioxide, niobium pentoxide, a tantalum oxide, a lanthanide oxide, and a molybdenum oxide, or a combination of at least two thereof is preferred for the oxide. A preferred lanthanide oxide is a lanthanum oxide. A preferred tantalum oxide is tantalum pentoxide. A preferred aluminium oxide is aluminium (III) oxide. Additionally or alternatively, one selected from the group consisting of silicon nitride, aluminium nitride, and silicon oxynitride, or a combination of at least two thereof is preferred for the at least one nitride.

In a preferred embodiment of the component, a minimum distance between the dielectric layer A and the dielectric layer B is less than 500 nm, preferably less than 450 nm, more preferably less than 400 nm, more preferably less than 350 nm, more preferably less than 300 nm, more preferably less than 250 nm, more preferably less than 200 nm, more preferably less than 150 nm, more preferably less than 100 nm, more preferably less than 90 nm, more preferably less than 80 nm, more preferably less than 70 nm, more preferably less than 60 nm, more preferably less than 50 nm, more preferably less than 40 nm, more preferably less than 30 nm, even more preferably less than 20 nm, most preferably less than 10 nm. This preferred embodiment is an 18th embodiment of the invention, that preferably depends on any of the preceding embodiments of the invention.

In a preferred embodiment of the component, the dielectric layer A adjoins the dielectric layer B. This preferred embodiment is a 19th embodiment of the invention, that preferably depends on any of the preceding embodiments of the invention.

In a preferred embodiment of the component, the first electrical conductor layer is at least partially embedded in the dielectric layer B. This preferred embodiment is a 20th embodiment of the invention, that preferably depends on any of the preceding embodiments of the invention.

In a preferred embodiment of the component, a further electrical connection extends from the first layer surface of the dielectric layer A through the dielectric layer A and at least partially through the dielectric layer B and electrically connects to the first electrical conductor layer. This preferred embodiment is a 21st embodiment of the invention, that preferably depends on any of the preceding embodiments of the invention.

In a preferred embodiment of the component, the layer sequence further comprises a further electrical conductor layer; wherein, in the view in the first direction at least the first region of the first electrical conductor layer, at least a first region of the further electrical conductor layer and at least the first region of the optical element layer overlap one another. This preferred embodiment is a 22nd embodiment of the invention, that preferably depends on any of the preceding embodiments of the invention.

In a preferred embodiment of the component, the further electrical conductor layer superimposes the optical element layer on a side of the optical element layer which faces the first side of the component, or on a side of the optical element layer which faces the further side of the component, or both. This preferred embodiment is a 23rd embodiment of the invention, that preferably depends on any of the preceding embodiments of the invention.

Preferably, the further electrical conductor layer superimposes the optical element layer on the same side of the optical element layer as the first electrical conductor layer.

In a preferred embodiment of the component, the further electrical conductor layer is arranged between the dielectric layer A and the optical element layer. This preferred embodiment is a 24th embodiment of the invention, that preferably depends on the 22nd or 23rd embodiment of the invention.

Preferably, the further electrical conductor layer is arranged between the first electrical conductor layer and the optical element layer.

In a preferred embodiment of the component, the further electrical conductor layer is at least partially embedded in the dielectric layer B. This preferred embodiment is a 25th embodiment of the invention, that preferably depends on any of the 22nd to 24th embodiments of the invention.

In a preferred embodiment of the component, a further electrical connection extends from the first layer surface of the dielectric layer A through the dielectric layer A and at least partially through the dielectric layer B and electrically connects to the further electrical conductor layer. This preferred embodiment is a 26th embodiment of the invention, that preferably depends on any of the 22nd to 25th embodiments of the invention.

In a preferred embodiment of the component, the further electrical conductor layer has a layer thickness of less than 1 $\mu$m, preferably less than 900 nm, more preferably less than 800 nm, more preferably less than 700 nm, more preferably less than 600 nm, more preferably less than 500 nm, more preferably less than 400 nm, more preferably less than 300 nm, more preferably less than 200 nm, more preferably less than 100 nm, more preferably less than 90 nm, more preferably less than 80 nm, more preferably less than 70 nm, more preferably less than 60 nm, more preferably less than 50 nm, more preferably less than 40 nm, more preferably less than 30 nm, more preferably less than 20 nm, more preferably less than 10 nm, more preferably less than 9 nm, more preferably less than 8 nm, more preferably less than 7 nm, more preferably less than 6 nm, more preferably less than 5 nm, more preferably less than 4 nm, more preferably less than 3 nm, more preferably less than 2 nm even more preferably less than 1 nm. This preferred embodiment is a 27th embodiment of the invention, that preferably depends on any of the 22nd to 26th embodiments of the invention.

Preferably, the lower limit of the thickness of the further electrical conductor layer is the thickness of an atomic monolayer or molecular monolayer of the material of the further electrical conductor layer. Preferably, the further electrical conductor layer consists of the same material as the first electrical conductor layer.

In a preferred embodiment of the component, the further electrical conductor layer consists of a number of layers of atoms or molecules, wherein the number of layers of atoms or molecules is at least 1, preferably in the range from 1 to 10, preferably from 1 to 9, more preferably from 1 to 8, more preferably from 1 to 7, more preferably from 1 to 6, more preferably from 1 to 5, more preferably from 1 to 4, more preferably from 1 to 3, even more preferably the number of layers of atoms or molecules is 1 or 2, most preferably 1. This preferred embodiment is a 28th embodiment of the invention, that preferably depends on any of the 22nd to 27th embodiments of the invention.

The layers of atoms or molecules follow one another in the first direction. Preferred layers of atoms are layers of carbon atoms.

In a preferred embodiment of the component, the first electrical conductor layer is at least partially embedded in the dielectric layer B at a first distance from the optical element layer. This preferred embodiment is a 29th embodiment of the invention, that preferably depends on any of the preceding embodiments of the invention.

In a preferred embodiment of the component, the further electrical conductor layer is at least partially embedded in the dielectric layer B at a further distance from the optical element layer; wherein the first distance is more than the further distance. This preferred embodiment is a 30th embodiment of the invention, that preferably depends on the 29th embodiment of the invention.

In a preferred embodiment of the component, the first distance is more than the further distance by a value in the range from 3 to 30 nm, preferably from 5 to 25 nm, more preferably from 10 to 15 nm. This preferred embodiment is a 31st embodiment of the invention, that preferably depends on the 30th embodiment of the invention.

In a preferred embodiment of the component, the first distance is in the range from 3 to 60 nm, preferably from 5 to 50 nm, more preferably from 10 to 25 nm. This preferred embodiment is a 32nd embodiment of the invention, that preferably depends on any of the 29th to 31st embodiments of the invention.

In a preferred embodiment of the component, the further distance is in the range from 0 to 30 nm, preferably from 0 to 25 nm, more preferably from 0 to 10 nm. This preferred embodiment is a 33rd embodiment of the invention, that preferably depends on any of the 30th to 32nd embodiments of the invention.

In a preferred embodiment of the component, the optical element layer is a full and continuous layer of the layer sequence. This preferred embodiment is a 34th embodiment of the invention, that preferably depends on any of the preceding embodiments of the invention.

In a preferred embodiment of the component, the optical element layer is at least partially embedded in a dielectric layer C; wherein the dielectric layer C is a layer of the layer sequence and follows the dielectric layer B in the first direction. This preferred embodiment is a 35th embodiment of the invention, that preferably depends on any of the 1st to 33rd embodiments of the invention.

Preferably, the dielectric layer C comprises, preferably consists of, an inorganic material C. The inorganic material C is preferably the same as the inorganic material A. Preferably, the dielectric layer C comprises the inorganic material C in a proportion of at least 50 wt.-%, more preferably at least 60 wt.-%, more preferably at least 70 wt.-%, more preferably at least 80 wt.-%, even more preferably at least 90 wt.-%, in each case based on the weight of the dielectric layer C. Preferably, the inorganic material C is an oxide, or a nitride, or both. In this context, one selected from the group consisting of silicon dioxide, an aluminium oxide, zirconium dioxide, hafnium oxide, titanium dioxide, niobium pentoxide, a tantalum oxide, a lanthanide oxide, and a molybdenum oxide, or a combination of at least two thereof is preferred for the oxide. A preferred lanthanide oxide is a lanthanum oxide. A preferred tantalum oxide is tantalum pentoxide. A preferred aluminium oxide is aluminium (III) oxide. Additionally or alternatively, one selected from the group consisting of silicon nitride, aluminium nitride, and silicon oxynitride, or a combination of at least two thereof is preferred for the at least one nitride. The optical element layer may adjoin the dielectric layer C or there may be at least one additional layer or material between the optical element layer and the dielectric layer C. A preferred dielectric layer C is a cladding to the optical element layer. This is particularly preferred if the optical element layer is a waveguide.

In a preferred embodiment of the component, a refractive index of the dielectric layer C is smaller than a refractive index of the optical element layer, preferably by at least 0.03 more preferably at least 0.1, most preferably at least 0.4. This preferred embodiment is a 36th embodiment of the invention, that preferably depends on the 35th embodiment of the invention.

In a preferred embodiment of the component, at least one, preferably each, of the following applies:

a] the first electrical conductor layer includes a second region, which, in the view in the first direction, does not overlap with the further electrical conductor layer, or does not overlap with the optical element layer, or does not overlap with any of both;

b] the first electrical conductor layer includes a third region, which, in the view in the first direction, does not overlap with the further electrical conductor layer, or does not overlap with the optical element layer, or does not overlap with any of both;

c] in the view in the first direction the first region of the first electrical conductor layer overlaps with the optical element layer over an entire surface of the optical element layer which faces towards the first side of the component;

d] the further electrical conductor layer includes a second region, which, in the view in the first direction, does not overlap with the first electrical conductor layer, or does not overlap with the optical element layer, or does not overlap with any of both;

e] in the view in the first direction the first region of the further electrical conductor layer overlaps with the optical element layer over the entire surface of the optical element layer which faces towards the first side of the component.

This preferred embodiment is a 37th embodiment of the invention, that preferably depends on any of the preceding embodiments of the invention.

Particularly preferred combinations of the above items are a] b], a] b] c], a] d], a] c] d] and a] c] d] e]. Preferably, the first region of the first electrical conductor layer is arranged between the second region and the third region, in each case of the first electrical conductor layer. Preferably, the second region of the first electrical conductor layer is arranged at a first end of the first electrical conductor layer and the third region of the first electrical conductor layer is arranged at a further end of the first electrical conductor layer, which is opposite the first end. Preferably, the second region of the further electrical conductor layer is arranged at an end of the further electrical conductor layer.

In a preferred embodiment of the component, one or two of the following applies:

a# the first electrical connection electrically connects to the second region of the first electrical conductor layer;

b# the further electrical connection electrically connects to the third region of the first electrical conductor layer;

c# the further electrical connection electrically connects to the second region of the further electrical conductor layer.

This preferred embodiment is a 38th embodiment of the invention, that preferably depends on the 37th embodiment of the invention.

Particularly preferred combinations of the above items are a# b# and a# c#.

In a preferred embodiment of the component, one or two of the following applies:

a~ the first electrical connection connects to a surface of the first electrical conductor layer, which faces towards the first side of the component;

b~ the further electrical connection connects to the surface of the first electrical conductor layer, which faces towards the first side of the component;

c~ the further electrical connection connects to a surface of the further electrical conductor layer, which faces towards the first side of the component;

d~ the first electrical connection extends through the first electrical conductor layer in the first direction;

e~ the further electrical connection extends through the first electrical conductor layer in the first direction;

f~ the further electrical connection extends through the further electrical conductor layer in the first direction.

This preferred embodiment is a 39th embodiment of the invention, that preferably depends on any of the preceding embodiments of the invention.

According to a~, the first electrical connection does not extend through the first electrical conductor layer. According to b~, the further electrical connection does not extend through the first electrical conductor layer. According to c~, the further electrical connection does not extend through the further electrical conductor layer. Particularly preferred combinations of the above items are a~ b~, a~ c~, d~ e~, d~ f, a~ e~, a~ f~, d~ b~ and d~ c~.

In a preferred embodiment of the component, at least one, preferably each, of the following applies to the dielectric layer A:

a} has an electrical conductivity which is less than $10^{-5}$ S/m, preferably less than $10^{-8}$ S/m, more preferably less than $10^{-11}$ S/m;

b} comprises, preferably consists of, at least one oxide, or at least one nitride, or both;

c} has a layer thickness in the range from 20 to 1,000 nm, preferably from 100 to 750 nm, more preferably from 200 to 600 nm.

This preferred embodiment is a 40th embodiment of the invention, that preferably depends on any of the preceding embodiments of the invention.

Particularly preferred combinations of the above items are a}, b}, c}, a} b}, a} c}, b} c}, a} b} c}. One selected from the group consisting of silicon dioxide, an aluminium oxide, zirconium dioxide, hafnium oxide, titanium dioxide, niobium pentoxide, a lanthanide oxide, and a tantalum oxide, or a combination of at least two thereof is preferred for the at least one oxide. A preferred lanthanide oxide is a lanthanum oxide. A preferred tantalum oxide is tantalum pentoxide. A preferred aluminium oxide is aluminium(III) oxide. Additionally or alternatively, one selected from the group consisting of silicon nitride, aluminium nitride, and silicon oxynitride, or a combination of at least two thereof is preferred for the at least one nitride.

In a preferred embodiment of the component, at least one, preferably each, of the following applies to the dielectric layer B:

a: has an electrical conductivity which is less than $10^{-5}$ S/m, preferably less than $10^{-9}$ S/m, more preferably less than $10^{-11}$ S/m;

b: comprises, preferably consists of, at least one oxide, or at least one nitride, or both;

c: has a layer thickness in the range from more than 0 up to 100 nm, preferably from 1 to 100 nm, more preferably from 5 to 50 nm, more preferably from 5 to 30 nm.

This preferred embodiment is a 41st embodiment of the invention, that preferably depends on any of the preceding embodiments of the invention.

Particularly preferred combinations of the above items are a:, b:, c:, a: b:, a: c:, b: c:, a: b: c:. One selected from the group consisting of silicon dioxide, an aluminium oxide, zirconium dioxide, hafnium oxide, titanium dioxide, niobium pentoxide, a lanthanide oxide, and a tantalum oxide, or a combination of at least two thereof is preferred for the at least one oxide. A preferred lanthanide oxide is a lanthanum oxide. A preferred tantalum oxide is tantalum pentoxide. A preferred aluminium oxide is aluminium(III) oxide. Additionally or alternatively, one selected from the group consisting of silicon nitride, aluminium nitride, and silicon oxynitride, or a combination of at least two thereof is preferred for the at least one nitride.

In a preferred embodiment of the component, at least one, preferably each, of the following applies to the first electrical conductor layer, or to the further electrical conductor layer, or to each of both:

a> has an electrical conductivity of at least 1 S/m, preferably at least 100 S/m, more preferably at least 1,000 S/m;

b> comprises, preferably consists of, one selected from the group consisting of carbon, a nitride, at least one metal, at least one metal alloy, at least one conductive oxide, at least one conductive polymer, at least one chalcogen, or a combination of at least two thereof;

c> has a length in the range from 10 $\mu$m to 1 mm, preferably from 20 to 500 $\mu$m, more preferably from 50 to 200 $\mu$m;

d> has a width in the range from 200 nm to 10 $\mu$m, preferably from 500 nm to 5 $\mu$m, more preferably from 1 to 3 $\mu$m;

e> has a layer thickness in the range from 0.1 to 40 nm, preferably from 0.1 to 30 nm, more preferably from 0.1 to 20 nm, more preferably from 0.1 to 10 nm, more preferably from 0.1 to 5 nm; even more preferably from 0.2 to 0.5 nm; f> consists in the first direction of a number of atomic layers which is at least 1, preferably in the range from 1 to 10, preferably from 1 to 6, more preferably from 1 to 5, more preferably from 1 to 4, more preferably from 1 to 3, even more preferably of 1 or 2, most preferably of 1.

This preferred embodiment is a 42nd embodiment of the invention, that preferably depends on any of the preceding embodiments of the invention.

Particularly preferred combinations of the above items are a>, b>, c>, d>, e>, f>, a> b> e>, a> b> f>, a> b>, a> e>, a> f>, a> e>, b> f>, c> d>, c> d> e>, c> d> f>, a> b> c> d> e> f>. In this context, a preferred form of carbon is graphene. A preferred conductive oxide is a titanate. A preferred titanate is calcium titanate. A preferred form of calcium titanate is perovskite. Preferably, the first electrical conductor layer consists of the same material as the further electrical conductor layer.

In a preferred embodiment of the component, the first electrical conductor layer, or the further electrical conductor layer, or each of both is a graphene sheet. This preferred embodiment is a 43rd embodiment of the invention, that preferably depends on any of the preceding embodiments of the invention.

In a preferred embodiment of the component, the first region of the first electrical conductor layer and the first region of the further electrical conductor layer are adapted and arranged to function together as a capacitor. This preferred embodiment is a 44th embodiment of the invention, that preferably depends on any of the 22nd to 43rd embodiments of the invention.

In a preferred embodiment of the component, the first region of the first electrical conductor layer and the first region of the further electrical conductor layer are adapted and arranged to have an RC time constant which is less than 50 ns, preferably less than 10 ns, more preferably less than 1 ns, and further preferably less than 0.5 ns. This preferred embodiment is a 45th embodiment of the invention, that preferably depends on any of the 22nd to 44th embodiments of the invention.

In a preferred embodiment of the component, at least one, preferably each, of the following applies to the dielectric layer C:

a- has an electrical conductivity which is less than $10^{-5}$ S/m, preferably less than $10^{-8}$ S/m, more preferably less than $10^{-11}$ S/m;

b- comprises, preferably consists of, at least one oxide, or at least one nitride, or both;

c- has a layer thickness in the range from 1 to 5,000 nm, preferably from 500 to 4,500 nm, more preferably from 1,000 to 4,000 nm, more preferably from 1,500 to 3,500 nm, even more preferably from 2,000 to 3,000 nm, most preferably from 2,100 to 2,500 nm.

This preferred embodiment is a 46th embodiment of the invention, that preferably depends on any of the 35th to 45th embodiments of the invention.

Particularly preferred combinations of the above items are a-, b-, c-, a- b-, a- c-, b- c-, a- b- c-. One selected from the group consisting of silicon dioxide, an aluminium oxide, zirconium dioxide, hafnium oxide, titanium dioxide, niobium pentoxide, a lanthanide oxide, and a tantalum oxide, or a combination of at least two thereof is preferred for the at least one oxide. A preferred lanthanide oxide is a lanthanum oxide. A preferred tantalum oxide is tantalum pentoxide. A preferred aluminium oxide is aluminium(III) oxide. Additionally or alternatively, one selected from the group consisting of silicon nitride, aluminium nitride, and silicon oxynitride, or a combination of at least two thereof is preferred for the at least one nitride.

In a preferred embodiment of the component, at least one, preferably each, of the following applies to the optical element layer:

a_ is adapted and arranged to be in opto-electronic interaction with the first region of the first electrical conductor layer, or the first region of the further electrical conductor layer, or both;

b_ comprises one selected from the group consisting of silicon, oxygen, aluminium, iridium, tantalum, titanium, nitrogen, lithium, niobium, indium, phosphorus, gallium, arsenic, barium, a chalcogenide, at least one polymer, and a resin, or a combination of at least two thereof;

c_ has a width in the range from 500 to 2,500 nm, preferably from 900 to 1,200 nm, more preferably from 950 to 1,050 nm;

d_ has a thickness in the range from 60 to 1,000 nm, preferably from 200 to 500 nm, more preferably from 300 to 400 nm.

This preferred embodiment is a 47th embodiment of the invention, that preferably depends on any of the preceding embodiments of the invention.

Particularly preferred combinations of the above items are a_, b_, c_, d_, b_ d_, c_ d_, b_ c_ d_, a_ b_ c_ d_. Preferred combinations of the materials mentioned in b_ include titanium dioxide, aluminium nitride, tantalum pentoxide, silicon nitride, aluminium oxide, silicon oxynitride, lithium niobate, silica, indium phosphide, gallium arsenide, indium gallium arsenide, barium titanate, and aluminium gallium arsenide. A preferred chalcogenide is a dichalcogenide, more preferably a transition metal dichalcogenide. In a preferred embodiment, the optical element layer has a thickness in the range from 300 to 500 nm, preferably from 320 to 420 nm, more preferably from 340 to 360 nm. Alternatively or additionally preferred the optical element layer has a width in the range from 200 to 2,000 nm, preferably from 500 to 1,500 nm, more preferably from 900 to 1,100 nm. In this embodiment, the optical element layer particularly preferable comprises, more preferably consists of, silicon nitride. According to a_, the optical element layer is preferably adapted and arranged for an evanescent electromagnetic field of an electromagnetic wave, which propagates through the optical element layer, to interact with the first region of the first electrical conductor layer, or the first region of the further electrical conductor layer, or both.

In a preferred embodiment of the component, the optical element layer is one selected from the group consisting of a waveguide, a grating, a prism, a lens, and a coupler, or a combination of at least two thereof. This preferred embodiment is a 48th embodiment of the invention, that preferably depends on any of the preceding embodiments of the invention.

In a preferred embodiment of the component, the waveguide is adapted and arranged for the propagation of electromagnetic waves which have wavelengths in the range from 300 nm to 3,000 nm, preferably in the range of 800 nm to 2,100 nm, and more preferably in the range of 1,250 nm to 1,650 nm; This preferred embodiment is a 49th embodiment of the invention, that preferably depends on the 48th embodiment of the invention.

A preferred waveguide is adapted and arranged for the propagation of electromagnetic waves that have wavelengths in at least one or all of the following ranges: 1,260 nm to 1,360 nm (also known as the Original Band or O-Band), 1,360 nm to 1,460 nm (also known as the Extend Band or E-Band), 1,460 nm to 1,530 nm (also known as the Short Band or S-Band), 1,530 nm to 1,565 nm (also known as the Conventional Band or C-Band), and 1,565 nm to 1,625 nm (also known as the Long Band or L-Band). In an aspect of the invention, it is particularly preferred that the waveguide is adapted and arranged for the propagation of electromagnetic waves that have wavelengths in the O-band, the C-band, or both.

In a preferred embodiment of the component, a first layer surface of the dielectric layer C faces towards the first side of the component, wherein a first surface of the optical element layer faces towards the first side of the component, wherein, in the first direction, the first surface of the optical element layer has a maximum distance from the first layer surface of the dielectric layer C in the range from 0 to 50 nm, preferably from 0 to 30 nm, more preferably from 0 to 20 nm. This, in particular, limits the height of any step from the first layer surface of the dielectric layer C to the first surface of the optical element layer and vice versa. This preferred embodiment is a 50th embodiment of the invention, that preferably depends on any of the 35th to 49th embodiments of the invention.

In a preferred embodiment of the component, the dielectric layer C and the optical element layer together form an embedded optical element layer; wherein each cross-section through the layer sequence includes a section of the embedded optical element layer, which extends in both lateral directions from a centre of the optical element layer in the cross-section by a length which is two times a dimension of the optical element layer in the cross-section, wherein in no cross-section through the layer sequence a difference between a minimum of the thickness of the embedded optical element layer in the section and a maximum of the embedded optical element layer in the section is more than 20 nm, preferably more than 10 nm, more preferably more than 5 nm. This, in particular, limits the height of any step between the dielectric layer C and the optical element layer. This preferred embodiment is a 51st embodiment of the invention, that preferably depends on any of the 35th to 50th embodiments of the invention.

In a preferred embodiment of the component, the layer sequence further comprises a substrate layer on a side of the optical element layer, which faces towards the further side of the component. This preferred embodiment is a 52nd embodiment of the invention, that preferably depends on any of the preceding embodiments of the invention.

In a preferred embodiment of the component, at least one, preferably each, of the following applies to the substrate layer:

a' comprises, preferably consists of, one selected from the group consisting of silicon, silicon carbide, gallium arsenide, indium phosphide, a glass, and a polymer, or a combination of at least two thereof;
b' has a length in the range from 5 mm to 1 m, preferably from 10 mm to 900 mm, more preferably from 20 mm to 800 mm, more preferably from 30 mm to 700 mm, more preferably from 50 mm to 600 mm, more preferably from 100 mm to 500 mm, more preferably from 150 mm to 400 mm, more preferably from 200 mm to 300 mm;
c' has a width in the range from 5 mm to 1 m, preferably from 10 mm to 900 mm, more preferably from 20 mm to 800 mm, more preferably from 30 mm to 700 mm, more preferably from 50 mm to 600 mm, more preferably from 100 mm to 500 mm, more preferably from 150 mm to 400 mm, more preferably from 200 mm to 300 mm;
d' has a layer thickness in the range from 10 $\mu$m to 1 mm, preferably from 675 to 800 $\mu$m.

This preferred embodiment is a 53$^{rd}$ embodiment of the invention, that preferably depends on the 52$^{nd}$ embodiment of the invention.

Particularly preferred combinations of the above items are a', b', c', d', b' d', a' d', b' c' d', b' c', a' b' c' d'.

In a preferred embodiment of the component, at least one, preferably each, of the following applies to the first electrical connection, to the further electrical connection, or to each of both:

> a* has an electrical conductivity which is at least 10$^3$ S/m, preferably at least 10$^5$ S/m, more preferably at least 10$^6$ S/m;
> b* comprises, preferably consists of, one selected from the group consisting of at least one metal, nitrogen, carbon, or a combination of at least two thereof;
> c* has a maximum diameter in the range from 20 to 2,000 nm, preferably from 30 to 1,500 nm, more preferably from 50 to 1,000 nm, even more preferably from 150 to 700 nm, most preferably from 200 to 500 nm.

This preferred embodiment is a 54$^{th}$ embodiment of the invention, that preferably depends on any of preceding embodiments of the invention.

Particularly preferred combinations of the above items are a*, b*, c*, a* b*, a* c*, b* c*, a* b* c*. A preferred metal is titanium. Preferred combinations of the constituents in b* are TiN, TaN and TiCN. A preferred form of carbon is graphene.

In a preferred embodiment of the component, a distance along the first direction between

- the first electrical conductor layer, or the further electrical conductor layer, or each of both, and
- the optical element layer

is at least 500 nm, preferably at least 600 nm, more preferably at least 700 nm, more preferably at least 800 nm, more preferably at least 900 nm, more preferably at least 1,100 nm, more preferably at least 1,200 nm, more preferably at least 1,300 nm, more preferably at least 1,400 nm, more preferably at least 1,500 nm, more preferably at least 1,600 nm, more preferably at least 1,700 nm, more preferably at least 1,800 nm, more preferably at least 1,900 nm, more preferably at least 2,000 nm, more preferably at least 2,100 nm, more preferably at least 2,200 nm, more preferably at least 2,300 nm, more preferably at least 2,400 nm, more preferably at least 2,500 nm, more preferably at least 2,600 nm, more preferably at least 2,700 nm, more preferably at least 2,800 nm, even more preferably at least 2,900 nm, most preferably at least 3,000 nm. This preferred embodiment is a 55$^{th}$ embodiment of the invention, that preferably depends on any of the preceding embodiments of the invention.

In a preferred embodiment of the component, the component is an opto-electronic component. This preferred embodiment is a 56$^{th}$ embodiment of the invention, that preferably depends on any of the preceding embodiments of the invention.

In a preferred embodiment of the component, the opto-electronic component is one selected from the group consisting of a modulator, a detector, a filter, an interferometer, and a bolometer, or a combination of at least two thereof. This preferred embodiment is a 57$^{th}$ embodiment of the invention, that preferably depends on the 56$^{th}$ embodiment of the invention.

A preferred detector is adapted and arranged for the detection of one selected from the group consisting of a virus, an antibody, a biomarker, and a biomolecule, or of a combination of at least two thereof. A further preferred detector is a photodetector or a bolometer or both.

A 58$^{th}$ embodiment of the invention is a method comprising as method steps in the following order:

> A. providing a component precursor, comprising a layer sequence, including at least the following layers superimposed on one another in the given order from a first side of the component precursor to a further side of the component precursor, which is opposite to the first side:
>
> > I. a dielectric layer A,
> > II. a dielectric layer B, and
> > III. an optical element layer;
>
> wherein the dielectric layer A is less resistant to a first etching method than the dielectric layer B, and the dielectric layer B is less resistant to a further etching method than the dielectric layer A; wherein the layer sequence further comprises a first electrical conductor layer; wherein, in a view in a first direction, which runs from the first side to the further side, at least a first region of the first electrical conductor layer and at least a first region of the optical element layer overlap one another; wherein a first layer surface of the dielectric layer A faces away from the dielectric layer B; wherein a first through-hole extends from the first layer surface of the dielectric layer A through the dielectric layer A;
> B. extending the first through-hole at least to the first electrical conductor layer by the further etching method; and
> C. introducing a first electrically conductive material into the first through-hole to obtain a first electrical connection, which extends from the first layer surface of the dielectric layer A through the dielectric layer A and at least partially through the dielectric layer B and electrically connects to the first electrical conductor layer.

Preferably, the dielectric layer A has one or more of the features of the dielectric layer A of the component of the invention according to any of its embodiments. Additionally or alternatively preferred, the dielectric layer B has one or more of the features of the dielectric layer B of the component of the invention according to any of its embodiments. Additionally or alternatively preferred, the optical element layer has one or more of the features of the optical element layer of the component of the invention according to any of its embodiments. Additionally or alternatively preferred, the first electrical conductor layer has one or more of the features of the first electrical conductor layer of the component of the invention according to any of its embodiments. Additionally or alternatively preferred, the first electrical connection has one or more of the features of the first electrical connection of the component of the invention according to any of its embodiments. In the method step C., the first through-hole is preferably filled or coated with the first electrically conductive material. Coating the first through-hole with the first electrically conductive material creates a liner of the first electrically conductive material. Preferably, the first through-hole is coated with a first electrically conductive material a and subsequently filled with a first electrically conductive material b, where the first electrically conductive material a is different from the first electrically conductive material b. Preferably, the first electrically conductive material a and the first electrically conductive material b are both metals. A preferred first electrically conductive material a is titanium. A preferred first electrically conductive material b is tungsten.

In a preferred embodiment of the method, the first electrical conductor layer superimposes the optical element layer on a side of the optical element layer which faces the first side of the component precursor, or on a side of the optical element layer which faces the further side of the component precursor, or both. This preferred embodiment is a 59th embodiment of the invention, that preferably depends on the 58th embodiment of the invention.

In a preferred embodiment of the method, the first electrical conductor layer is arranged between the dielectric layer A and the optical element layer. This preferred embodiment is a 60th embodiment of the invention, that preferably depends on the 58th or 59th embodiment of the invention.

In a preferred embodiment of the method, the method step A. includes superimposing the dielectric layer A to the dielectric layer B by a dry method. This preferred embodiment is a 61st embodiment of the invention, that preferably depends on any of the 58th to 60th embodiments of the invention.

The dry method does not include applying a liquid precursor of the dielectric layer A, which includes a liquid vehicle, in particular a solvent, to a substrate. A preferred dry method is a vapour deposition method or atomic layer deposition. A preferred vapour deposition method is chemical vapour deposition or physical vapour deposition.

In a preferred embodiment of the method, the method step A. includes forming the first through-hole in the dielectric layer A by the first etching method. This preferred embodiment is a 62nd embodiment of the invention, that preferably depends on any of the 58th to 61st embodiments of the invention.

In a preferred embodiment of the method, in the method step A., additionally a further through-hole extends from the first layer surface of the dielectric layer A through the dielectric layer A. This preferred embodiment is a 63rd embodiment of the invention, that preferably depends on any of the 58th to 62nd embodiments of the invention.

In a preferred embodiment of the method, the method step A. includes forming the further through-hole in the dielectric layer A by the first etching method. This preferred embodiment is a 64th embodiment of the invention, that preferably depends on the 63rd embodiment of the invention.

In a preferred embodiment of the method, the method step B. additionally includes extending the further through-hole at least to the first electrical conductor layer by the further etching method; wherein the method step C. additionally includes introducing a further electrically conductive material into the further through-hole to obtain a further electrical connection, which extends from the first layer surface of the dielectric layer A through the dielectric layer A and at least partially through the dielectric layer B and electrically connects to the first electrical conductor layer. This preferred embodiment is a 65th embodiment of the invention, that preferably depends on the 63rd or 64th embodiment of the invention.

In the method step C., the further through-hole is preferably filled or coated with the further electrically conductive material. Coating the further through-hole with the further electrically conductive material creates a liner of the further electrically conductive material. Preferably, the further through-hole is coated with a further electrically conductive material a and subsequently filled with a further electrically conductive material b, where the further electrically conductive material a is different from the further electrically conductive material b. Preferably, the further electrically conductive material a and the further electrically conductive material b are both metals. A preferred further electrically conductive material a is titanium. A preferred further electrically conductive material b is tungsten.

In a preferred embodiment of the method, the method comprises a further method step of forming a further through-hole, which extends from the first layer surface of the dielectric layer A through the dielectric layer A, by the first etching method. This preferred embodiment is a 66th embodiment of the invention, that preferably depends on any of the 58th to 62nd embodiments of the invention.

In a preferred embodiment of the method, the further method step is conducted between the method steps B. and C., or after the method step C. This preferred embodiment is a 67th embodiment of the invention, that preferably depends on the 66th embodiment of the invention.

In a preferred embodiment of the method, the method additionally comprises as method steps in the following order:

A) extending the further through-hole at least to the first electrical conductor layer by the further etching method; and
B) introducing a further electrically conductive material into the further through-hole to obtain a further electrical connection, which extends from the first layer surface of the dielectric layer A through the dielectric layer A and at least partially through the dielectric layer B and electrically connects to the first electrical conductor layer.

This preferred embodiment is a 68th embodiment of the invention, that preferably depends on any of the 63rd, 64th, 66th or 67th embodiments of the invention.

In the method step B), the further through-hole is preferably filled or coated with the further electrically conductive material. Coating the further through-hole with the further electrically conductive material creates a liner of the further electrically conductive material. Preferably, the further through-hole is coated with a further electrically conductive material a and subsequently filled with a further electrically conductive material b, where the further electrically conductive material a is different from the further electrically conductive material b. Preferably, the further electrically conductive material a and the further electrically conductive material b are both metals. A preferred further electrically conductive material a is titanium. A preferred further electrically conductive material b is tungsten.

In a preferred embodiment of the method, the first etching method includes steps of

A] superimposing a photoresist layer to the dielectric layer A on a side of the dielectric layer A, which is opposite the dielectric layer B;
B] partially irradiating the photoresist layer in at least one region of the photoresist layer;
C] removing the at least one region or another at least one region of the photoresist layer, thereby obtaining a first auxiliary through-hole in the photoresist layer, or a further auxiliary through-hole in the photoresist layer, or both; and
D] introducing a first etchant into the first auxiliary through-hole, or the further auxiliary through-hole, or both, and forming the first through-hole in the dielectric layer A, or the further through-hole in the dielectric layer A, or both.

This preferred embodiment is a 69th embodiment of the invention, that preferably depends on any of the 58th to 68th embodiments of the invention.

In a preferred embodiment of the method, the first etching method further includes a step
E] removing the photoresist layer.

This preferred embodiment is a 70th embodiment of the invention, that preferably depends on the 69th embodiment of the invention.

In a preferred embodiment of the method, in the method step A. the layer sequence further comprises a further electrical conductor layer, wherein, in the view in the first direction at least the first region of the first electrical conductor layer, at least a first region of the further electrical conductor layer and at least the first region of the optical element layer overlap one another. This preferred embodiment is a 71st embodiment of the invention, that preferably depends on any of the 58th to 70th embodiments of the invention.

Preferably, the further electrical conductor layer superimposes the optical element layer on a side of the optical element layer which faces the first side of the component precursor, or on a side of the optical element layer which faces the further side of the component precursor, or both. Particularly preferred, the further electrical conductor layer is arranged between the dielectric layer A and the optical element layer, more preferably between the first electrical conductor layer and the optical element layer.

In a preferred embodiment of the method, the method step B. additionally includes extending the further through-hole at least to the further electrical conductor layer by the further etching method; wherein the method step C. additionally includes introducing a further electrically conductive material into the further through-hole to obtain a further electrical connection, which extends from the first layer surface of the dielectric layer A through the dielectric layer A and at least partially through the dielectric layer B and electrically connects to the further electrical conductor layer. This preferred embodiment is a 72nd embodiment of the invention, that preferably depends on the 71st embodiment of the invention.

In the method step C., the further through-hole is preferably filled or coated with the further electrically conductive material. Coating the further through-hole with the further electrically conductive material creates a liner of the further electrically conductive material. Preferably, the further through-hole is coated with a further electrically conductive material a and subsequently filled with a further electrically conductive material b, where the further electrically conductive material a is different from the further electrically conductive material b. Preferably, the further electrically conductive material a and the further electrically conductive material b are both metals. A preferred further electrically conductive material a is titanium. A preferred further electrically conductive material b is tungsten.

In a preferred embodiment of the method, the method additionally comprises as method steps in the following order:

A) extending the further through-hole at least to the further electrical conductor layer by the further etching method; and

B) introducing a further electrically conductive material into the further through-hole to obtain a further electrical connection, which extends from the first layer surface of the dielectric layer A through the dielectric layer A and at least partially through the dielectric layer B and electrically connects to the further electrical conductor layer.

This preferred embodiment is a 73rd embodiment of the invention, that preferably depends on the 71st embodiment of the invention.

In the method step B), the further through-hole is preferably filled or coated with the further electrically conductive material. Coating the further through-hole with the further electrically conductive material creates a liner of the further electrically conductive material. Preferably, the further through-hole is coated with a further electrically conductive material a and subsequently filled with a further electrically conductive material b, where the further electrically conductive material a is different from the further electrically conductive material b. Preferably, the further electrically conductive material a and the further electrically conductive material b are both metals. A preferred further electrically conductive material a is titanium. A preferred further electrically conductive material b is tungsten.

In a preferred embodiment of the method, the method step A), or the method steps A) and B) is/are conducted between the method steps B. and C., or after the method step C.

This preferred embodiment is a 74th embodiment of the invention, that preferably depends on any of the 68th to 73rd embodiments of the invention.

In a preferred embodiment of the method, one or two of the following applies:

a~ the first electrical connection electrically connects to the first electrical conductor layer in that the first electrical connection contacts a surface of the first electrical conductor layer, which faces towards the first side of the component precursor;

b~ the further electrical connection electrically connects to the first electrical conductor layer in that the further electrical connection contacts the surface of the first electrical conductor layer, which faces towards the first side of the component precursor;

c~ the further electrical connection electrically connects to the further electrical conductor layer in that the further electrical connection contacts a surface of the further electrical conductor layer, which faces towards the first side of the component precursor;

d~ before introducing the first electrically conductive material into the first through-hole, the first through-hole is extended through the first electrical conductor layer in the first direction, and the first electrical connection electrically connects to the first electrical conductor layer in that the first electrical connection extends through the first electrical conductor layer in the first direction;

e~ before introducing the further electrically conductive material into the further through-hole, the further through-hole is extended through the first electrical conductor layer in the first direction, and the further electrical connection electrically connects to the first electrical conductor layer in that the further electrical connection extends through the first electrical conductor layer in the first direction;

f~ before introducing the further electrically conductive material into the further through-hole, the further through-hole is extended through the further electrical conductor layer in the first direction, and the further electrical connection electrically connects to the further electrical conductor layer in that the further electrical connection extends through the further electrical conductor layer in the first direction.

This preferred embodiment is a 75th embodiment of the invention, that preferably depends on any of the 58th to 74th embodiments of the invention.

Particularly preferred combinations of the above items are a~ b~, a~ c~, d~ e~ and d~ f~.

In a preferred embodiment of the method, in the method step A., the optical element layer is a full and continuous layer of the layer sequence. This preferred embodiment is a 76th embodiment of the invention, that preferably depends on any of the 58th to 75th embodiments of the invention.

In a preferred embodiment of the method, wherein, in the method step A., the optical element layer is at least partially embedded in a dielectric layer C; wherein the dielectric layer C is a layer of the layer sequence and follows the dielectric layer B in the first direction. This preferred embodiment is a 77th embodiment of the invention, that preferably depends on any of the 58th to 75th embodiments of the invention.

In a preferred embodiment of the method, in the method step A., the layer sequence further comprises a substrate layer on a side of the optical element layer, which faces towards the further side of the component precursor. This preferred embodiment is a 78th embodiment of the invention, that preferably depends on any of the 58th to 77th embodiments of the invention.

Preferably, the substrate layer has one or more of the features of the substrate layer of the component of the invention according to any of its embodiments.

In a preferred embodiment of the method, after the method step C., the method further comprises a step of separating a region of the layer sequence from the component precursor, thereby obtaining a component, wherein the region includes at least a section of the optical element layer. This preferred embodiment is a 79th embodiment of the invention, that preferably depends on any of the 58th to 78th embodiments of the invention.

In a preferred embodiment of the method, the first through-hole or the further through-hole or each of both has a maximum diameter in the range from 20 to 2,000 nm, preferably from 30 to 1,500 nm, more preferably from 50 to 1,000 nm, even more preferably from 150 to 700 nm, most preferably from 200 to 500 nm. This preferred embodiment is an 80th embodiment of the invention, that preferably depends on any of the 58th to 79th embodiments of the invention.

In a preferred embodiment of the method, the component precursor is an opto-electronic component precursor. This preferred embodiment is an 81st embodiment of the invention, that preferably depends on any of the 58th to 80th embodiments of the invention.

In a preferred embodiment of the method, the method is for producing a component from the component precursor. This preferred embodiment is an 82nd embodiment of the invention, that preferably depends on any of the 58th to 81st embodiments of the invention.

In this context, a preferred component is the component of the invention according to any of its embodiments.

In a preferred embodiment of the method, the component is an opto-electronic component. This preferred embodiment is an 83rd embodiment of the invention, that preferably depends on the 82nd embodiment of the invention.

An 84th embodiment of the invention is a component obtainable by the method according to any of the 58th to 83rd embodiments of the invention.

An 85th embodiment of the invention is an electronic device, comprising the component according to any of the 1st to 57th, or 84th embodiments of the invention.

In a preferred embodiment of the electronic device, the electronic device is a computing device or a memory or both. This preferred embodiment is an 86th embodiment of the invention, that preferably depends on the 85th embodiment of the invention.

The computing device may be any type of computing device for any kind of purpose. A preferred computing device is one selected from the group consisting of a CPU (Central Processing Unit), a GPU (Graphics Processing Unit), a XPU (X-Processing Unit), and an ASIC (Application Specific Integrated Circuit), or a combination of at least two thereof.

In a preferred embodiment of the electronic device, wherein the component is designed and arranged for one selected from the group consisting of

a.. to provide a communication between a first integrated circuit of the electronic device and a further integrated circuit of the electronic device;
b.. to provide a communication between a first part of an integrated circuit of the electronic device and a further part of the integrated circuit; and
c.. to inject an optical vector in an optical network and/or to read out an optical vector from an optical network; or
d.. a combination of at least two thereof.

This preferred embodiment is an 87th embodiment of the invention, that preferably depends on the 85th or 86th embodiment of the invention.

Here, communication is an exchange of data, preferably of binary data. In a preferred embodiment according to the above alternative a.., the component is part of the first integrated circuit or of the further integrated circuit. In another preferred embodiment according to the above alternative a.., the component is not part of the first integrated circuit or of the further integrated circuit. In a preferred embodiment according to the above alternative b.., the component is part of the integrated circuit. In a preferred embodiment according to the above alternative c.., the component is part of the optical network. A preferred optical network is designed to perform optical computing. A preferred optical network which is designed to perform optical computing is an optical neuromorphic network or a fast Fourier accelerator or both.

An 88th embodiment of the invention is a use of the component according to any of the 1st to 57th, or 84th embodiments of the invention for producing an electronic device.

An 89th embodiment of the invention is a use of the component according to any of the 1st to 57th, or 84th embodiments of the invention for

a_establishing a communication between a first integrated circuit and a further integrated circuit;
b_ establishing a communication between a first part of an integrated circuit and a further part of the integrated circuit;

or

c_injecting an optical vector in an optical network and/or reading out an optical vector from an optical network.

Here, communication is an exchange of data, preferably of binary data. In a preferred embodiment according to the above alternative a_, the component is part of the first integrated circuit or of the further integrated circuit. In another preferred embodiment according to the above alternative a_, the component is not part of the first integrated circuit or of the further integrated circuit. In a preferred embodiment according to the above alternative b_, the component is part of the integrated circuit. In a preferred embodiment according to the above alternative c_, the component is part of the optical network. A preferred optical network is designed to perform optical computing. A preferred optical network which is designed to perform optical computing is an optical neuromorphic network or a fast Fourier accelerator or both.

Features described as preferred in one category of the invention, for example according to the composite, are analogously preferred in an embodiment of the other categories according to the invention, such as the method and the uses. Throughout this document, disclosures of ranges should preferably be understood to include both end points of the range. Furthermore, each disclosure of a range in the document should preferably be understood as also disclosing preferred sub-ranges in which one end point is excluded or both end points are excluded. For example, a disclosure of a range from 200 nm to 800 nm is to be understood as disclosing a range that includes both of the end points 200 nm and 800 nm. Furthermore, it is to be understood as also disclosing a range that includes the end point 200 nm but excludes the end point 800 nm, a range that excludes the end point 200 nm but includes the end point 800 nm, and a range that excludes both end points 200 nm and 800 nm.

Layer Sequence

The layers of the layer sequence have been joined to one another in a planar manner, preferably over their entire surfaces. Two layers are joined together when their adhesion to each other exceeds Van der Waals forces of attraction. Due to their specific nature, the latter definition does not apply to layers of graphene. Preferably, layers joined to one another are one selected from the group consisting of joined with one another by coating. Layers joined to one another by coating are preferably joined to one another by vapour deposition coating or atomic layer deposition or both. A preferred form of vapour deposition coating is physical vapour deposition (PVD) or chemical vapour deposition coating (CVD). A preferred form of CVD is plasma enhanced chemical vapour deposition (PECVD). Unless stated otherwise, in a layer sequence, the layers may follow one another indirectly, i.e., with one or at least two intermediate layers, or directly, i.e., with no intermediate layer. This is the case especially in the form of words in which one layer is superimposed to another layer. A form of words in which a layer sequence comprises enumerated layers means that at least the layers specified are present in the sequence specified. This form of words does not necessarily mean that these layers follow on directly from one another. In a preferred embodiment, superimposed layers adjoin each other. A form of words in which two layers adjoin one another means that these two layers follow on from one another directly and hence with no intermediate layer. Generally, each layer of the layer sequence may be a full and continuous layer of the layer sequence or a partial or discontinuous layer. A full layer of the layer sequence, laterally extends over the full area of the layer sequence, as opposed to a partial layer which has a width or length or both which is smaller than the width or length or both of the overall layer sequence. A continuous layer does not have any gaps, except for gaps, in particular through-holes, for electrical connections. Opposed to this, a discontinuous layer may be present over the full area of the layer sequence, however, with gaps, which are not filled with electrical connections. In particular, a discontinuous layer may be present in a patterned or structured form. It is preferred that one selected from the group consisting of the dielectric layer A, the dielectric layer B, the dielectric layer C, and the substrate layer, or a combination of at least two thereof, particularly preferable each of these, is a full and continuous layer of the layer sequence. Additionally or alternatively preferred, the first electrical conductor layer or the further electrical conductor layer or each of both is a partial layer. In a preferred embodiment, the optical element layer is a full and continuous layer of the layer sequence. In another embodiment, the optical element layer is a partial layer, which is preferably at least partially embedded in the dielectric layer C. Preferably, one selected from the group consisting of the dielectric layer A, the dielectric layer B, the dielectric layer C, the optical element layer, the first electrical conductor layer, the further electrical conductor layer, and the substrate layer, or a combination of at least two thereof, preferably each of the preceding, is a plane-parallel layer. Preferably, at least two selected from the group consisting of the dielectric layer A, the dielectric layer B, the dielectric layer C, the optical element layer, the first electrical conductor layer, the further electrical conductor layer, and the substrate layer, preferably each combination two of the preceding, are plane-parallel to one another.

First Direction

The first direction runs from the first side to the further side of the component or component precursor, respectively. The first direction is the direction in which the layers of the layer sequence follow one another. The first direction is preferably perpendicular to a layer plane of the dielectric layer A, or a layer plane of the dielectric layer B, or to each of both. The first direction of the component precursor is the same as the first direction of the component produced from this component precursor.

Dielectric Layers

Any material and layer which the skilled person deems suitable in the context of the invention comes into consideration for the dielectric layers A, B and C. Each dielectric layer comprises, preferably consists of, a dielectric. Each dielectric layer comprises a dielectric in a proportion of at least 50 wt.-%, more preferably at least 60 wt.-%, more preferably at least 70 wt.-%, more preferably at least 80 wt.-%, even more preferably at least 90 wt.-%, in each case based on the weight of the respective dielectric layer. It follows that each dielectric layer is an electrical insulator that can be polarised by an applied electric field. The dielectric layer A consists of a different material than the dielectric layer B. Preferably, the dielectric layers A and C consist of the same material. One selected from the group consisting of the dielectric layer A, the dielectric layer B, and the dielectric layer C, or a combination of at least two thereof is preferably obtainable by vapour deposition, preferably by PVD or CVD or both. One selected from the group consisting of the dielectric layer A, the dielectric layer B, and the dielectric layer C, or a combination of at least two thereof is preferably not a polymer layer. One selected from the group consisting of the dielectric layer A, the dielectric layer B, and the dielectric layer C, or a combination of at least two thereof preferably has a total proportion of polymers of less than 50 wt.-%, more preferably less than 40 wt.-%, more preferably less than 30 wt.-%, more preferably less than 20 wt.-%, more preferably less than 10 wt.-%, even preferably less than 5 wt.-%, most preferably of 0 wt.-%, in each case based on the weight of the respective dielectric layer. One selected from the group consisting of the dielectric layer A, the dielectric layer B, and the dielectric layer C, or a combination of at least two thereof is preferably not an organic layer. One selected from the group consisting of the dielectric layer A, the dielectric layer B, and the dielectric layer C, or a combination of at least two thereof preferably has a total proportion of organic materials of less than 50 wt.-%, more preferably less than 40 wt.-%, more preferably less than 30 wt.-%, more preferably less than 20 wt.-%, more preferably less than 10 wt.-%, even preferably less than 5 wt.-%, most preferably of 0 wt.-%, in each case based on the weight of the respective dielectric layer. One selected from the group consisting of the dielectric layer A, the dielectric layer B, and the dielectric layer C, or a combination of at least two thereof is preferably an inorganic layer. One selected from the group consisting of the dielectric layer A, the dielectric layer B, and the dielectric layer C, or a combination of at least two thereof preferably comprises one or more inorganic materials in sum in proportion of at least 50 wt.-%, more preferably at least 60 wt.-%, more preferably at least 70 wt.-%, more preferably at least 80 wt.-%, even more preferably at least 90 wt.-%, in each case based on the weight of the respective dielectric layer. Preferably, one selected from the group consisting of the dielectric layer A, the dielectric layer B, and the dielectric layer C, or a combination of at least two thereof consists of one or more, preferably one, inorganic material(s). Preferably, the dielectric layer A is hardmask. Additionally or alternatively preferred, the dielectric layer B is hardmask. Preferably, the dielectric layer A qualifies as a hardmask for the further etching method. A preferred dielectric layer A is a hardmask for the further etching method. Additionally or alternatively preferred, the dielectric layer B qualifies as a hardmask for the first etching method. A preferred dielectric layer B is a hardmask for the first etching method.

Optical Element Layer

Each optical element in the form of a layer which the skilled person deems suitable in the context of the invention comes into consideration for the optical element layer. The optical element layer is preferably adapted and arranged for an opto-electronic interaction with the first electrical conductor layer or the further electrical conductor layer or both. This means that

- an electrical current or electrical charge in the first electrical conductor layer or in the further electrical conductor layer or both can modify electromagnetic waves that are in the optical element layer, in particular that propagate through the optical element layer, or are in contact with the optical element layer, or
- electromagnetic waves that are in the optical element layer, in particular that propagate through the optical element layer, or are in contact with the optical element layer can modify an electrical current or electrical charge in the first electrical conductor layer or in the further electrical conductor layer or both, or
- both.

Herein, an optical element is an element that is arranged and designed to manipulate electromagnetic waves. A preferred optical element layer is one selected from the group consisting of a transmission optic, a conversion optic, and a reflection optic, or a combination of at least two of them. A transmission optic is an optic through which electromagnetic waves pass in order to manipulate them. A preferred transmission optic is one selected from the group consisting if a waveguide, a lens, and transmission grating, or a combination of at least two thereof. Here, a waveguide is particularly preferred. A conversion optic is an optic arranged and configured to alter a wavelength of electromagnetic radiation. This may, for example, serve to adjust a colour of light. A reflective optic is an optic that, in order to manipulate the electromagnetic waves, in particular a propagation direction of the electromagnetic waves, reflects electromagnetic waves. A preferred reflective optic is a mirror or a reflection grating.

Waveguide

A waveguide is an element which manipulates a direction of propagation of electromagnetic waves in order to guide the electromagnetic waves and thereby propagate the electromagnetic waves with reduced loss of energy, as compared to the decrease of intensity according to the inverse square law which applies to the expansion of electromagnetic waves into three-dimensional space, by restricting the transmission of energy to one direction. A preferred waveguide is one selected from the group consisting of a strip waveguide, a rib waveguide, a slot waveguide, a buried waveguide, and a diffused waveguide, or a combination of at least two thereof. Additionally or alternatively preferred, the waveguide comprises at least one or all of the following: silicon, oxygen, aluminium, iridium, tantalum, titanium, nitrogen, lithium, niobium, indium, phosphorus, gallium, arsenic, barium, a chalcogenide, at least one polymer, a resin, and a combination of at least two thereof. Examples of combinations of the aforementioned materials include titanium dioxide, aluminium nitride, tantalum pentoxide, silicon nitride, aluminium oxide, silicon oxynitride, lithium niobate, silica, indium phosphide, gallium arsenide, indium gallium arsenide, barium titanate, and aluminium gallium arsenide. A preferred chalcogenide is a dichalcogenide, more preferably a transition metal dichalcogenide. Additionally or alternatively preferred, the waveguide is adapted and arranged for the propagation of electromagnetic waves that have wavelengths in at least one or all of the following ranges: 1260 nm to 1360 nm (also known as the Original Band or O-Band), 1360 nm to 1460 nm (also known as the Extend Band or E-Band), 1460 nm to 1530 nm (also known as the Short Band or S-Band), 1530 nm to 1565 nm (also known as the Conventional Band or C-Band), and 1565 nm to 1625 nm (also known as the Long Band or L-Band). In an aspect of the invention, it is particularly preferred that the waveguide is adapted and arranged for the propagation of electromagnetic waves that have wavelengths in the O-band, the C-band, or both. Where it is disclosed that the waveguide is adapted and arranged for the propagation of electromagnetic waves that have wavelengths in a given wavelength range, this should not be understood to mean that the waveguide is necessarily only adapted for the propagation of electromagnetic waves in that given wavelength range. Rather, it should preferably be understood to mean that the waveguide is at least adapted and arranged for the propagation of electromagnetic waves in the given wavelength range.

Additionally or alternatively preferred, the component of the invention comprises a cladding to the waveguide. Preferably, the cladding at least partially surrounds the waveguide. Preferably, the cladding surrounds the waveguide over the full length of the waveguide, but surrounds the waveguide over at least part of the waveguide's perimeter, Preferably, the cladding surrounds more than 50 % of the perimeter of the waveguide. Additionally or alternatively preferred, the cladding surrounds the perimeter of the waveguide, except for a side of the waveguide which faces the first side of the component or component precursor. The cladding has a refractive index which is less than the refractive index of the waveguide. Preferably, the dielectric layer C is the cladding. In this context, the waveguide is preferably at least partially embedded in the dielectric layer C.

Electrical Conductor Layers

Each electrical conductor in the form of a layer which the skilled person deems suitable in the context of the invention comes into consideration for the first and further electrical conductor layers. Thus, each electrical conductor is a layer which is electrically conductive. Preferably, the first and further electrical conductor layers consist of the same material. Additionally or alternatively preferred, the first and further electrical conductor layers have the same layer thickness. Additionally or alternatively preferred, the first and further electrical conductor layers are plane-parallel to one another. A preferred electrical conductor layer consists of graphene. This preference applies to each single one of the electrical conductor layers taught herein, and also to each combination of the electrical conductor layers taught herein. Graphene is an allotrope of carbon consisting of at least 1 layer of carbon atoms which are arranged in a hexagonal lattice structure. Thus, a preferred electrical conductor layer which consists of graphene may consist of a monolayer of carbon atoms or of multiple layers of carbon atoms stacked upon one another without forming graphite. The presence of graphene is determined by Raman spectroscopy as described below in the "Composition" test method.

Electrical Connection

Each of the first and further electrical connections is an electrically conductive path which was preferably obtained by filling a cavity, preferably a through-hole, with an electrically conductive material or by coating walls of the cavity with an electrically conductive material or both.

Preferably, a length of the first electrical connection or of the further electrical connection or each of both is at least in sections, preferably entirely, about parallel to the first direction. A preferred electrical connection is referred to as a via in the technical field of the invention. A via is a through-hole that extends through two or more adjacent layers of the layer sequence, wherein the through-hole is at least partially filled or at least partially coated or both with an electrically conductive material, preferably a metal, that establishes an electrical connection through the two or more adjacent layers. A preferred electrical connection is circular in cross-section.

Substrate

For the substrate layer of the component and its precursor each substrate which the skilled person deems suitable comes into consideration. A preferred substrate layer is one selected from the group consisting of a glass plate, a polymer plate, a polymer sheet and a wafer.

Opto-Electronic Component

The component of the invention preferably is an opto-electronic component, more preferably a graphene-based opto-electronic component. An opto-electronic component is an electronic component which is designed and adapted for modification of electromagnetic waves by an electrical current or an electrical charge, or for modification of an electrical current or an electrical charge by electromagnetic waves. An example of a modification of electromagnetic waves is a modulation of the electromagnetic waves. Modification of an electromagnetic wave should preferably be understood as the modification of one or more properties of an electromagnetic wave. Examples of the properties include amplitude, phase, frequency, and polarisation. In an aspect of the invention, it is preferred that an amplitude is modified. Examples of modifying at least one property of an electromagnetic wave is a modulation of the electromagnetic wave, an at least partial absorption of the electromagnetic wave, or both. A preferred modulation of an electromagnetic wave is a modulation of an amplitude of the electromagnetic wave.

Hardmask

A hardmask is a layer of material generally known in semiconductor processing as an etch mask which is used instead of a polymer or other organic soft resist material, i.e., instead of a photoresist. Usually, in the prior art hardmasks are used only when the material to be etched is itself an organic polymer. In this case, the hardmask is usually removed after it has served its purpose as a mask for etching.

Photolithography

Photolithography is the most common method for semiconductor fabrication of integrated circuits. In integrated circuit manufacturing, photolithography is a general term used for an etching technique which involves light to produce an etch mask on the material layer to be etched. Typically, ultraviolet light is used to transfer a geometric design from an optical mask to a lightsensitive chemical, i.e., to a photoresist layer, coated on the material layer to be etched. The photoresist either breaks down or hardens where it is exposed to the light. The etch mask is then created by removing the softer parts of the coating with appropriate solvents, also known in this case as developers. A photoresist (also known simply as a resist) is thus a photosensitive material which may be used to form a patterned coating on a surface. Photoresists typically comprise a resin, a sensitizer and a vehicle or solvent. The resin serves as a binder which provides physical properties such as adhesion and chemical resistance. The sensitizer has a photoactive compound which renders the photoresists photosensitive. The vehicle or solvent keeps the resist liquid.

Etching and Etchant

The of an etching method is the atom, radical, molecule or ion which directly interacts with the material surface to remove part of the material by chemical interaction or physical interaction or both. A preferred chemical interaction is a chemical reaction. A preferred physical interaction is sputtering. If herein reference is made to an etchant by the symbol of a chemical element, the reference encompasses atoms, radicals, molecules and ions of the element.

A wet etching method is an etching method in which the etchant is provided in liquid form or as part of a liquid composition which includes the etchant. The liquid etchant or liquid composition, which includes the etchant, is applied to the target surface by, preferably by spin-coating. A dry etching method is an etching method in which the etchant is provided in the form of a gas or plasma, or as part of a gas or plasma. In each case, the gas or plasma may be created from a liquid.

Overlap

Regions of two or more layers overlap one another in a view in a certain direction if these regions follow one after the other congruently in the certain direction.

Partially Embedded

A layer which is at least partially embedded in another layer is a partial layer of the layer sequence. A layer which is at least partially embedded in another layer is preferably surrounded by the other layer over its full length. Additionally or alternatively preferred more than 50 % of a perimeter of the layer are surrounded by the other layer. Preferably, the other layer surrounds the perimeter of the layer, except for a side of the layer which faces the first side of the component or component precursor. Preferably, the layer and the other layer together form a combined layer, wherein a surface of the combined layer which faces the first side of the component or component precursor is a combination of surfaces of the layer and of the other layer, each of which each faces the first side.

Distances

A distance between two elements is the length of the shortest straight line which connects the two elements.

Method steps

The method steps of the method according to the invention are carried out in the order of their symbols. In principle, method steps with immediately successive symbols can be carried out one after the other, at the same time or overlapping in time. If multiple operations are performed in the same method step, these operations may be conducted in any order, at the same time or overlapping in time as long as not given or technically required otherwise.

Chemical Elements

Wherever herein the abbreviation of a chemical elements is used without further specification this includes references to atoms, molecules and ions of this elements as such as well as the presence of atoms ore ions of this element in a chemical compound.

TEST METHODS

The following test methods were used within the context of the invention. Unless stated otherwise, the measurements were conducted at an ambient temperature of 23 °C, an ambient air pressure of 100 kPa (0.986 atm) and a relative air humidity of 50 %.

Preparation of a Sample Lamella

For producing a sample lamella, a focused ion beam is used to make a cut through the layered structure of the component or component precursor. The section plane is parallel to the layer sequence, i.e., to the direction of the layer thickness. The thickness of the sample lamella is 50 nm. The sample lamella preparation is conducted automatically using the Thermo Scientific Au-toTEM 5 software from Thermo Fisher Scientific Inc.

Dimensions

The length and width of the layers of the component and component precursor are determined using scanning electron microscopy (SEM).
The layer thicknesses of layers of the component and component precursor, except for layers of graphene, are measured using transmission electron microscopy (TEM) on a sample lamella which is prepared as described above. The sample lamella and TEM are also used to measure the distance between layers. The TEM device is calibrated and used according to the standard ISO 29301:2017.

RC Time Constant

The RC time constant between the first electrical conductor layer and the further electrical conductor layer is measured using a Vector Network Analyzer (VNA) connected to the component using shielded cable transmission lines.

The connection to the component is made using an RF semiconductor Probe Tip (the Infinity Probe commercially available from FormFactor Inc. (USA)). The measurement setup is calibrated to isolate the RC behaviour of the component in order to suppress the influence of the interconnection on the measurements. The VNA is calibrated using the multireflect-thru method described in Lewandowski and Gu (2017), A Multireflect-Thru Method of Vector Network Analyzer Calibration, IEEE Transactions on Microwave Theory and Techniques, 65, 3, 905.

Composition

Except for graphene, the composition of a layer is determined using electron energy-loss spectroscopy (EELS). This method is conducted on a sample lamella of the component or component precursor. The sample lamella is prepared as described above. EELS is described in F. Hofer et al., Fundamentals of electron energy-loss spectroscopy, EMAS 2015 Workshop, IOP Conf. Series: Materials Science and Engineering 109, 012007 (2016).

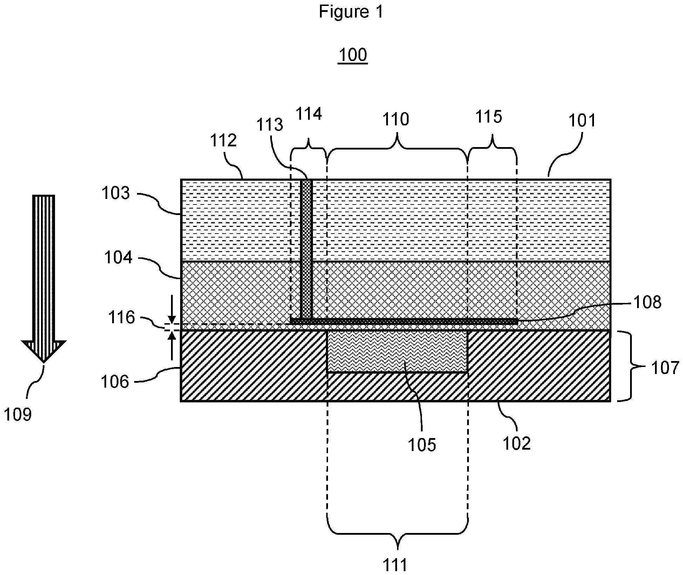

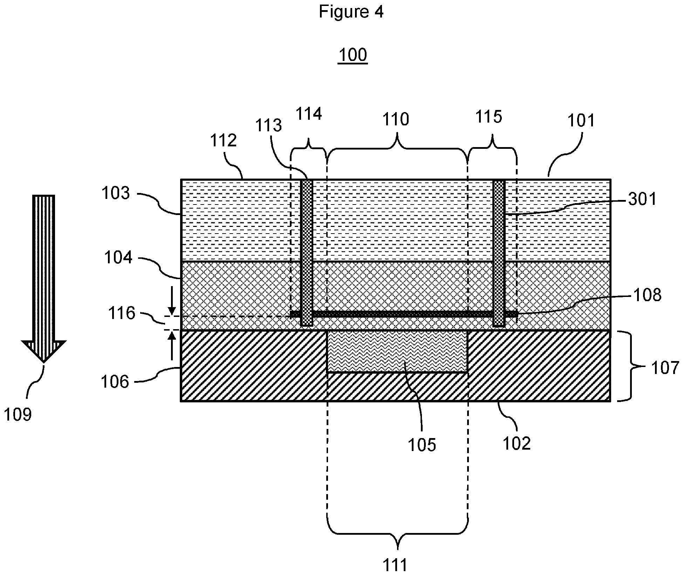

The presence of graphene can be determined using Raman spectroscopy. A 514 nm Raman spectrum is measured. The G peak is at about 1,581 $cm^{-1}$. The 2D peak depends on the laser wavelength and is often at about 2,700 $cm^{-1}$. The G peak and the 2D peak together identify a carbon layer. The shape of the 2D peak indicates the number of graphene layers as shown in Figure 4a, 4c, and 4f of Andrea C. Ferrari and Denis M. Basko, Raman spectroscopy as a versatile tool for studying the properties of graphene, nature nanotechnology, vol. 8, no. 4, Art. no. 4, Apr. 2013, DOI: 10.1038/NNANO.2013.46. Furthermore, Figure 1f shows a shift in the shear mode (C) for multilayer graphene, where single layer graphene (SLG) shows no shear mode.

The Raman spectra of graphite and multilayer graphene consist of two fundamentally different sets of peaks. The peaks of the first set are caused by in-plane vibrations. Examples of such peaks are the D, G and 2D peaks. Those peaks are present in single layer graphene (SLG) and also in multilayer graphene. The peaks of the other set are caused by motions of the planes relative to one another, either perpendicular or parallel to their normal. Examples of such peaks are the shear (C) modes and the layer-breathing modes (LBMs). Those peaks are not present in SLG. The low-frequency $E_{2g}$ mode in graphite, also called mode C, is at about 42 $cm^{-1}$. This mode C is sensitive to the interlayer coupling. Thus, the absence of the mode C peak generally indicates SLG. Particular care, however, has to be taken to make sure that the mode C peak is not absent for another reason. Further, the mode C scales with the number of carbon layers. For bilayer graphene (BLG), for example, the mode C is at about 31 $cm^{-1}$. The mode C peak frequency is below the notch and edge filter cut-off of many spectrometers, particularly those used for production-line monitoring. This problem is overcome by combining a BragGrate filter with a single monochromator. This allows to measure Pos(C) for an arbitrary number of graphene layers.

Selectivity

The etch rate of an etching method for a certain layer is measured as follows: A test layer with a thickness of 500 nm and of the same material and made by the same method as the layer to be studied is provided. The test layer is then subjected to the etching method, i.e., to the etching environment with the etchant of the etching method to be studied. The time required to reduce the thickness of the test layer by 300 nm is measured (*i.e.,* after the etching method has been completed, the test layer has a thickness of 200 nm). An intermediate etching rate is then determined by dividing 300 nm with the measured time. The test is repeated 10 times to obtain 10 intermediate etching rates. The etching rate of the etching method for the layer to be studied is then calculated by taking the average of the 10 intermediate etching rates.

The selectivity of a certain etching method (first or further etching method) for the dielectric layer A over the dielectric layer B is the ratio of the etching rate of this etching method for the layer A to the etching rate of this etching method for the layer B. The selectivity of a certain etching method (first or further etching method) for the dielectric layer B over the dielectric layer A is the ratio of the etching rate of this etching method for the layer B to the etching rate of this etching method for the layer A. Therein, all etching rates are determined as generally described above.

Refractive Index

First, a sample lamella of the layer structure of the component or component precursor to be studied is prepared as described above. Using the sample lamella, the layer thicknesses of the individual layers is determined by TEM as also described above. Based on the measured layer thicknesses, the sample lamella is further used to determine the refractive index of the layer of interest by ellipsometric measurement according to ISO 23131:2021(en). Model 7.3 is used as a reference.

Electrical Conductivity

The electrical conductivity of thin films is measured through a four-point probe. A four-point probe comprises four equally spaced, co-linear electrical probes. It operates by applying a DC current (I) between the outer two probes and measuring the resultant voltage drop ($\Delta V$) between the inner two probes. For thin films where the film thickness (t) is at least 1,000 times the probe spacing, the sheet resistance ($R_S$) is:

$$R_S = \frac{\pi}{\ln(2)} \frac{\Delta V}{I} \approx 4.53236 \frac{\Delta V}{I}$$

$\Delta V$ is the change in voltage measured between the inner probes, and I is the current applied between the outer probes. The electrical conductivity ($\sigma$) is defined as:

$$\sigma = \frac{1}{R_S \cdot t}$$

Responsivity of Photodetectors

The responsivity of a photodetector is the measure of the optical to electrical conversion efficiency. It is expressed by the value of the photocurrent in mA generated by each mW of optical signal. To measure the responsivity a tunable laser is used to provide a wavelength tunable light source and a variable attenuator adjusts the optical power level that is sent to the photodetector under test. For the measurement, the optical power level has to be kept high enough, more than about 50 $\mu$W, to avoid non-linear effects in the photodetector, but still low enough to represent the low energy consumption case desired by the telecommunication application. Therefore, a transimpedance amplifier (TIA) must be used to linearly convert the rather weak photocurrent into a voltage signal. A voltmeter is then used to measure the voltage signal at the output of the TIA which is proportional to the photocurrent generated by the photodetector. A calibrated optical power meter is used to measure the absolute power level of the optical signal. The voltage signal obtained from the photocurrent is measured for 10 equidistantly spaced optical power levels. For each of these optical power levels, the ratio of voltage signal (mV) to the power level as measure by the optical power meter in mW is calculated. The arithmetic mean over the 10 ratios is calculated as a measure of the responsivity of the photodetector.

Modulation Speed of Modulators

Here, the modulation speed of a modulator is its cut-off frequency. In order to determine the modulation speed of a modulator, it is connected to a calibrated vector network analyser (VNA) with a bandwidth that is higher than the cut-off frequency of the modulator. The RF output port of the VNA is connected to the electrical signal input from the modulator and the RF input signal in the VNA is connected to a calibrated photoreceiver. A photoreceiver as well as all other equipment in the measurement, such as cables, connectors, probe tips, etc. should be fully de-embedded from the measurement. It is to be made sure that the bandwidth of the photoreceiver and the other components of the test setup are not a limiting factor for the measurement of the modulation speed. A laser sends light into the optical input port of the modulator, where the light is modulated and guided to the calibrated photoreceiver. The VNA measures the S21 (forward transmission) parameter, which is the ratio of the RF input to the RF output with both magnitude and phase terms. The S21 parameter is measured in a frequency range from DC up to well beyond the cut-off frequency of the modulator with an increasing frequency load. The lowest frequency at which the S21 parameter amplitude drops by 3 dB compared to the maximum amplitude at DC is referred to as the modulation speed.

EXAMPLES

The invention is illustrated further by way of examples. The invention is not restricted to the examples.
Graphene for all of the Examples and Comparative Examples is commercially available from Graphenea S.A. (Spain), Graphene Laboratories Inc. (USA) and Grolltex Inc (USA).
For each of the Examples 1 and 2 and the Comparative Examples 1 and 2, 5,000 photodetectors are prepared on a standard silicon wafer with a diameter of 200 mm and a thickness of 725 mm as substrate.

Example 1

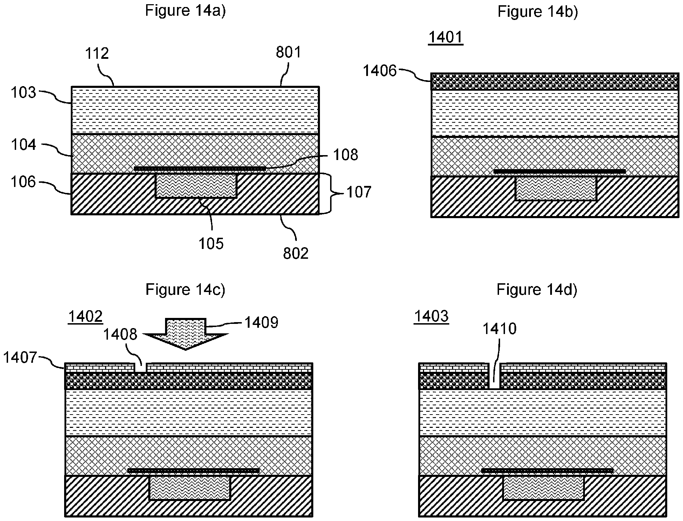

A component precursor as schematically shown in Figure 14a) (without the substrate) is prepared. In the Figure 14a), the direction of the length of the component precursor and the individual layers points into the figure plane. A 3,000 nm thick layer of $SiO_2$ is created on the silicon wafer by wet thermal oxidation. A 350 nm thick layer of SiN is coated on the preceding layer of $SiO_2$ by PVD. The layer of SiN is patterned by photolithography to obtain one partial layer of SiN per photodetector to be prepared as waveguide. Reactive ion etching is used to partially remove the SiN. A further layer of $SiO_2$ is deposited on the first $SiO_2$ layer and the waveguides by PECVD in order to embed the waveguides. The further layer of $SiO_2$ is 1,000 nm thick. The further layer of $SiO_2$ is planarised and removed down to the top surfaces of the waveguides by chemical mechanical polishing (CMP). An embedded waveguide layer is obtained. Subsequently, a 10 nm thick layer of $Al_2O_3$ is coated on the embedded waveguide layer by atomic layer deposition. A single graphene layer is coated on the layer of $Al_2O_3$ by graphene lamination. The layer of graphene is 1 atomic carbon layer thick, i.e., has a thickness of less than 1 nm. Photolithography with dry etching is used to pattern the graphene layer in order to obtain one partial graphene layer per waveguide, where each partial graphene layer covers the entire width of the respective waveguide and extends further on both sides of the waveguide as illustrated in Figure 14a). Further, a 20 nm thick layer of $Al_2O_3$ is coated on the first layer of $Al_2O_3$ and the patterned graphene layer by atomic layer deposition. Thus, the graphene sheets are fully embedded in $Al_2O_3$. A further layer of $SiO_2$ is coated on the embedded graphene layer by PECVD. This $SiO_2$ layer is 30 nm thick. Each of the graphene sheets has a length of 100 $\mu$m.

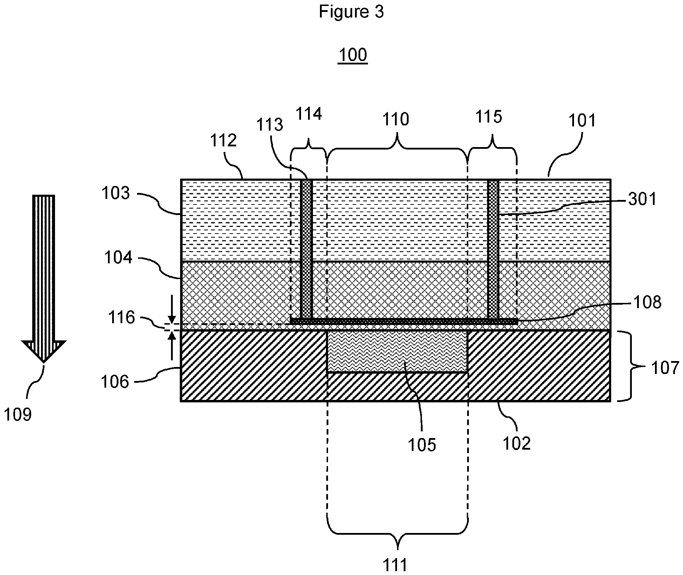

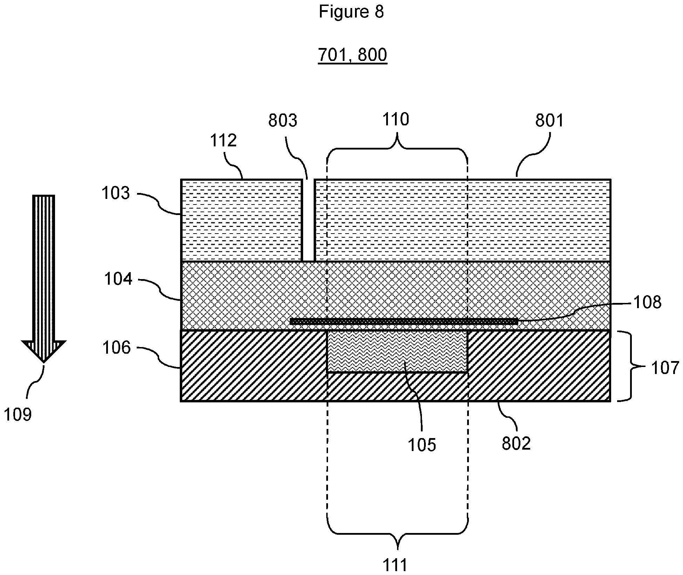

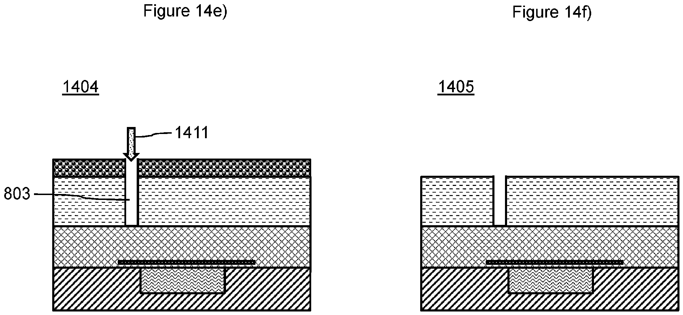

Through-holes which extend from the top $SiO_2$ surface of the precursor through the upper $SiO_2$ layer are prepared by lithography as generally illustrated in Figures 14a) to 14f) for a single through-hole. The removal of the photoresist which is indicated in the step from Figure 14e) to 14f) is done by an oxygen plasma. Each through-hole is circular in cross-section and has a diameter of 500 nm. Here, along the length of the graphene sheets, equidistantly every 1 $\mu$m a pair of 2 through-holes per graphene sheet is formed. The first through-hole of each pair extends from the top surface of the precursor in the direction of a first end region of the respective graphene sheet as illustrated in Figure 14f). The other through-hole of each pair extends from the top surface of the precursor in the direction of the other end region of the respective graphene sheet which is opposite the first end region in a direction of the width of the graphene sheet. Reactive ion etching is used as first etching method to create the through-holes in the top $SiO_2$ layer (dielectric layer A). The through-holes are used to prepare vias as generally illustrated for a single via in Figures 8 to 10. Here, atomic layer etching is used as further etching method to extend the through-holes partially through the $Al_2O_3$ (dielectric layer B) to the top surfaces of the graphene sheets. The selectivity of the first etching method for the dielectric layer A over the dielectric layer B is 50. The selectivity of the further etching method for the dielectric layer A over the dielectric layer B is 0.1. The through-holes are filled with a titanium liner by PVD and then with a tungsten metal fill by CVD. The first via of each pair electrically connects to the top surface of the respective graphene sheet in its first end region. The other via of each pair connects to the top surface of the same graphene sheet in its other end region. Superfluous via material on the top $SiO_2$ layer is removed by CMP. A single one of the thus obtained 5,000 photodetectors on the wafer is illustrated in Figure 3.

Example 2

A component precursor as schematically shown in Figure 14a) (without the substrate) is prepared as described above for the Example 1. Further, through-holes which extend from the top $SiO_2$ surface of the precursor through the upper $SiO_2$ layer are prepared by lithography as also described above for the Example 1.

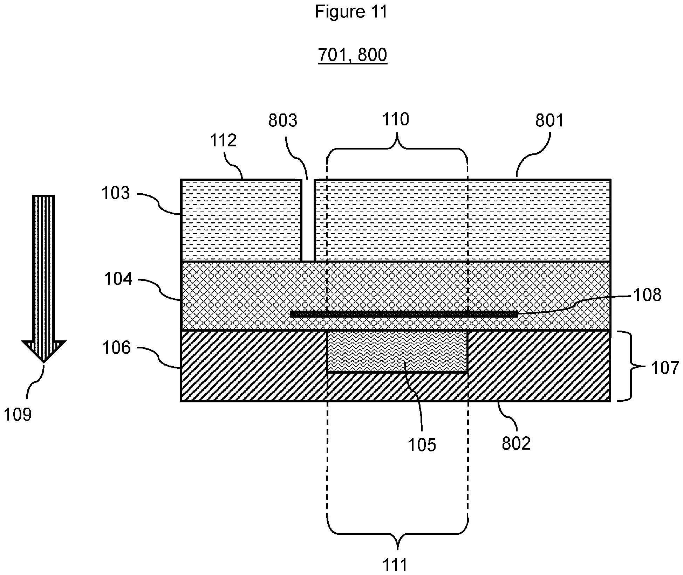

The pairs of 2 through-holes each 1 $\mu$m of the length of each graphene sheet are used to prepare vias as generally illustrated for a single via in Figures 11 to 13. Here, reactive ion etching is used as further etching method to extend the through-holes partially through the $Al_2O_3$ (dielectric layer B) and also through the respective graphene sheet. The selectivity of the first etching method for the dielectric layer A over the dielectric layer B is 50. The selectivity of the further etching method for the dielectric layer A over the dielectric layer B is 0.2. The through-holes are filled with a titanium liner by PVD and then with a tungsten metal fill by CVD. The first via of each pair extends through the respective graphene sheet in its first end region and thus electrically connects to the graphene sheet. The other via of each pair extends through the same graphene sheet in its other end region and thus electrically connects to the graphene sheet. Superfluous via material on the top $SiO_2$ layer is removed by CMP. A single one of the thus obtained 5,000 photodetectors on the wafer is illustrated in Figure 4.

Comparative Example 1

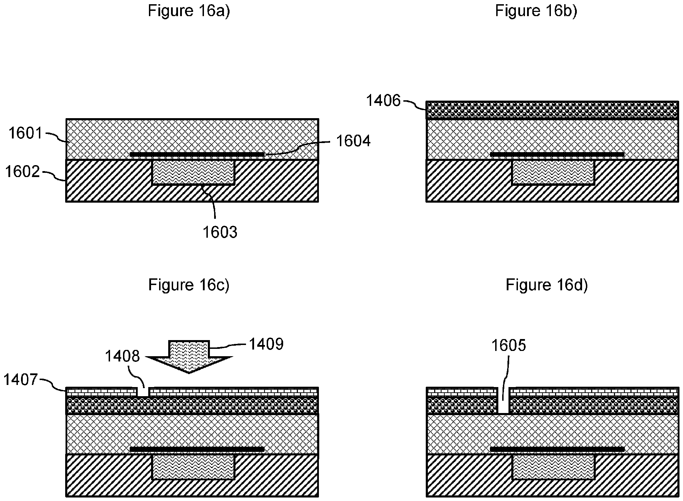

A component precursor as schematically shown in Figure 16a) (without the substrate) is prepared. In the Figure 16a), the direction of the length of the component precursor and the individual layers points into the figure plane. A 3,000 nm thick layer of $SiO_2$ is created on the silicon wafer by wet thermal oxidation. A 350 nm thick layer of SiN is coated on the preceding layer of $SiO_2$ by PVD. The layer of SiN is patterned by photolithography to obtain one partial layer of SiN per photodetector to be prepared as waveguide. Reactive ion etching is used to partially remove the SiN. A further layer of $SiO_2$ is deposited on the first $SiO_2$ layer and the waveguides by PECVD in order to emb the waveguides. The further layer of $SiO_2$ is 1,000 nm thick. The further layer of $SiO_2$ is planarised and removed down to the top surfaces of the waveguides by CMP. An embedded waveguide layer is obtained. Subsequently, a 10 nm thick layer of $Al_2O_3$ is coated on the embedded waveguide layer by atomic layer deposition. A single layer of graphene is coated on the layer of $Al_2O_3$ by graphene lamination. The layer of graphene is 1 atomic carbon layer thick, i.e., has a thickness of less than 1 nm. Photolithography with dry etching is used to pattern the graphene layer in order to obtain one partial graphene layer per waveguide, where each partial graphene layer covers the entire width of the respective waveguide and extends further on both sides of the waveguide as illustrated in Figure 16a). Further, a 20 nm thick layer of $Al_2O_3$ is coated on the first layer of $Al_2O_3$ and the patterned graphene layer by atomic layer deposition. Thus, the graphene sheets are fully embedded in $Al_2O_3$. Each of the graphene sheets has a length of 100 $\mu$m.

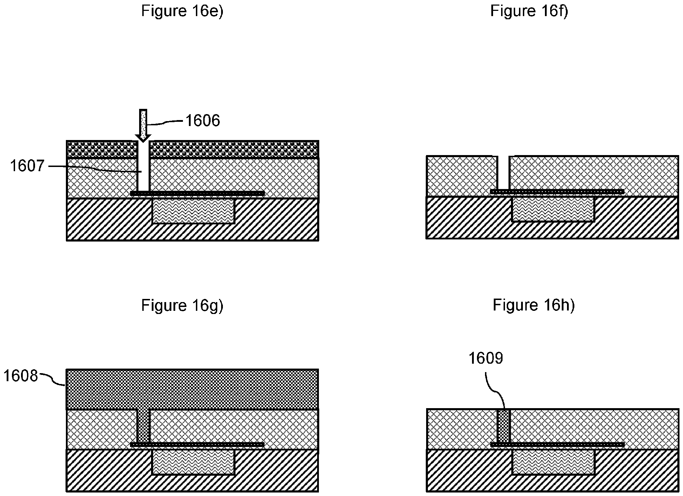

Through-holes which extend from the top $Al_2O_3$ surface of the precursor partially through the $Al_2O_3$ layer to the top surfaces of the graphene sheets are prepared by photolithography as generally illustrated in Figures 16a) to 16f) for a single through-hole. The removal of the photoresist which is indicated in the step from Figure 16e) to 16f) is done by an oxygen plasma. Each through-hole is circular in cross-section and has a diameter of 500 nm. Here, along the length of the graphene sheets, equidistantly every 1 $\mu$m a pair of 2 through-holes per graphene sheet is formed. The first through-hole of each pair extends from the top surface of the precursor to the top surface of the respective graphene sheet in a first end region of the graphene sheet as illustrated in Figure 16f). The other through-hole of each pair extends from the top surface of the precursor to the top surface of the same graphene sheet in the other end region of the graphene sheet which is opposite the first end region in a direction of the width of the graphene sheet. Atomic layer etching is used to create the through-holes. Acetone is used to clean the top surface of the precursor from remaining photoresist. The through-holes are used to prepare vias as generally illustrated for a single via in Figures 16g) and 16h). For this purpose, the through-holes are filled with a titanium liner by PVD and then with a tungsten metal fill by CVD. The first via of each pair electrically connects to the top surface of the respective graphene sheet in its first end region. The other via of each pair connects to the top surface of the same graphene sheet in its other end region. Superfluous via material on the top $Al_2O_3$ layer is removed by a dry etch after a lithographic contact definition.

Comparative Example 2

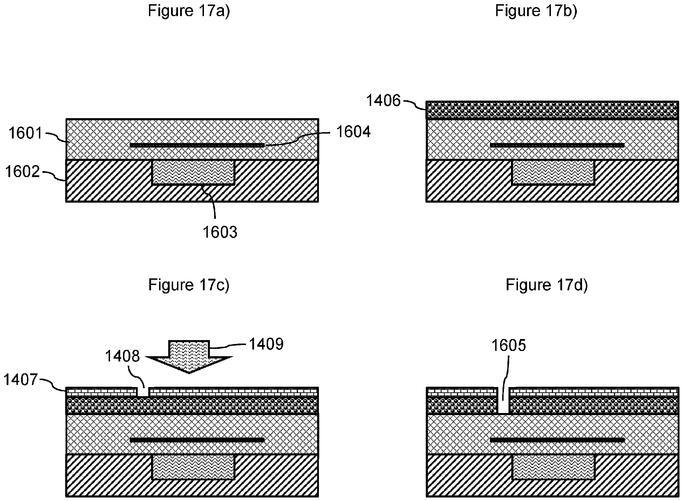

A component precursor as schematically shown in Figure 17a) (without the substrate) is prepared in the same way as described above for the Comparative Example 1.

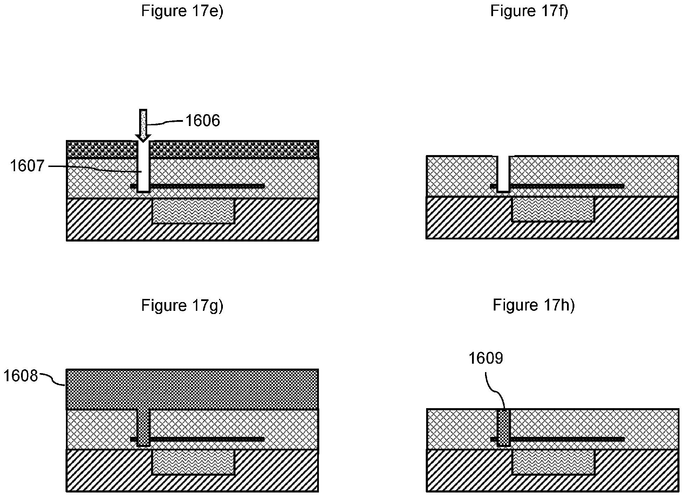

Through-holes which extend from the top $Al_2O_3$ surface of the precursor partially through the $Al_2O_3$ layer and completely through the graphene sheets are prepared by photolithography as generally illustrated in Figures 17a) to 17f) for a single through-hole. The removal of the photoresist which is indicated in the step from Figure 17e) to 17f) is done by an oxygen plasma. Each through-hole is circular in cross-section and has a diameter of 500 nm. Here, along the length of the graphene sheets, equidistantly every 1 $\mu$m a pair of 2 through-holes per graphene sheet is formed. The first through-hole of each pair extends from the top surface of the precursor through the respective graphene sheet in a first end region of the graphene sheet as illustrated in Figure 17f). The other through-hole of each pair extends from the top surface of the precursor through the same graphene sheet in the other end region of the graphene sheet which is opposite the first end region in a direction of the width of the graphene sheet. Reactive ion etching is used to create the through-holes. Acetone is used to clean the top surface of the precursor from remaining photoresist. The through-holes are used to prepare vias as generally illustrated for a single via in Figures 17g) and 17h). For this purpose, the through-holes are filled with a titanium liner by PVD and then with a tungsten metal fill by CVD. The first via of each pair electrically extends through the respective graphene sheet in its first end region and thus electrically connects to the graphene sheet. The other via of each pair extends through the same graphene sheet in its other end region and thus electrically connects to the graphene sheet. Superfluous via material on the top $Al_2O_3$ layer is removed by a dry etch after a lithographic contact definition.

For each of the Examples 3 and 4 and the Comparative Examples 3 and 4, 5,000 modulators are prepared on a standard silicon wafer with a diameter of 200 mm and a thickness of 725 mm as substrate.

Example 3

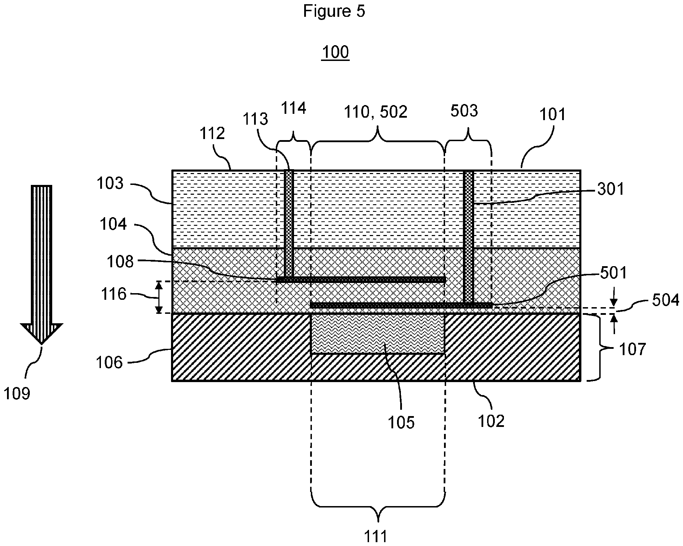

Modulators as illustrated in Figure 5 are prepared. In the Figure 5, the direction of the length of the modulator and the individual layers points into the figure plane. A 3,000 nm thick layer of $SiO_2$ is coated on the silicon wafer by PECVD. A 350 nm thick layer of SiN is created on the preceding layer of $SiO_2$ by wet thermal oxidation. The layer of SiN is patterned by photolithography to obtain one partial layer of SiN per modulator to be prepared as waveguide. Reactive ion etching is used to partially remove the SiN. A further layer of $SiO_2$ is deposited on the first $SiO_2$ layer and the waveguides by PECVD in order to embed the waveguides. The further layer of $SiO_2$ is 1,000 nm thick. The further layer of $SiO_2$ is planarised and removed down to the top surfaces of the waveguides by CMP. An embedded waveguide layer is obtained. Subsequently, a 10 nm thick layer of $Al_2O_3$ is coated on the embedded waveguide layer by atomic layer deposition. A first single layer of graphene is coated on the layer of $Al_2O_3$ by graphene lamination. The layer of graphene is 1 atomic carbon layer thick, i.e., has a thickness of less than 1 nm. Photolithography with dry etching is used to pattern the graphene layer in order to obtain one partial graphene layer per waveguide, where each partial graphene layer covers the entire width of the respective waveguide and extends further on one side of the waveguide as illustrated in Figure 5. A 10 nm thick layer of $Al_2O_3$ is coated on the first layer of $Al_2O_3$ and the first patterned graphene layer by atomic layer deposition in order to embed the graphene sheets of the first patterned graphene layer. Subsequently, a further layer of the graphene is coated on the $Al_2O_3$ by graphene lamination. The thickness of the further layer of graphene is the same as the thickness of the first layer of graphene. Photolithography with wet etching is used to pattern the further graphene layer in order to obtain one further partial graphene layer per waveguide, where each further partial graphene layer covers the entire width of the respective waveguide and extends further on the other side of the waveguide as illustrated in Figure 5. Further, a 20 nm thick layer of $Al_2O_3$ is coated on the $Al_2O_3$ and the further patterned graphene layer by atomic layer deposition. Thus, the further graphene sheets are also fully embedded in $Al_2O_3$. Subsequently, a further layer of $SiO_2$ is coated on the embedded graphene layers by PECVD. This $SiO_2$ layer is 30 nm thick. Each of the graphene sheets has a length of 100 $\mu$m.

Through-holes which extend from the top $SiO_2$ surface of the precursor through the upper $SiO_2$ layer are prepared by photolithography. The removal of the photoresist is done by an oxygen plasma. Each through-hole is circular in cross-section and has a diameter of 500 nm. Here, along the length of the graphene sheets, equidistantly every 1 $\mu$m a pair of 2 through-holes per graphene sheet is formed. The first through-hole of each pair extends from the top surface of the precursor in the direction of the end region of the upper graphene sheet, which does not overlap with the respective lower graphene sheet and the respective waveguide. The other through-hole of each pair extends from the top surface of the precursor in the direction of the end region of the respective lower graphene sheet, which does not overlap with the respective upper graphene sheet and the respective waveguide. Reactive ion etching is used as first etching method to create the through-holes in the top $SiO_2$ layer (dielectric layer A). The through-holes are used to prepare vias. Here, atomic layer etching is used as further etching method to extend the through-holes partially through the $Al_2O_3$ (dielectric layer B) to the top surfaces of the graphene sheets. The selectivity of the first etching method for the dielectric layer A over the dielectric layer B is 50. The selectivity of the further etching method for the dielectric layer A over the dielectric layer B is 0.1. The through-holes are filled with a titanium liner by PVD and then with a tungsten metal fill by CVD. The first via of each pair electrically connects to the top surface of the respective upper graphene sheet in its non-overlapping end region. The other via of each pair connects to the top surface of the respective lower graphene sheet in its non-overlapping end region. Superfluous via material on the top $SiO_2$ layer is removed by CMP. A single one of the thus obtained 5,000 modulators on the wafer is illustrated in Figure 5.

Example 4

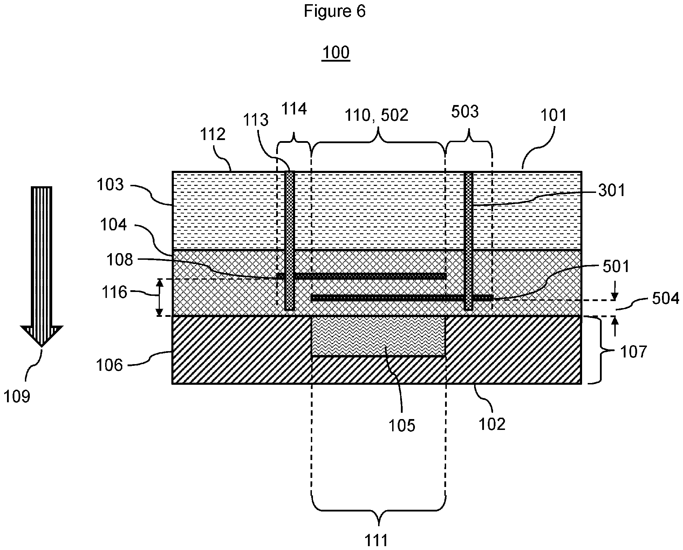

Modulators as illustrated in Figure 6 are prepared. In the Figure 6, the direction of the length of the modulator and the individual layers points into the figure plane. A precursor with embedded waveguide layer, pairs of upper and lower graphene sheets embedded in $Al_2O_3$, and a top layer of $SiO_2$ is prepared as described above for the Example 3.

Through-holes which extend from the top $SiO_2$ surface of the precursor through the upper $SiO_2$ layer are prepared by photolithography as described above for the Example 3. The through-holes are used to prepare vias. Here, reactive ion etching is used as further etching method to extend the through-holes partially through the $Al_2O_3$ (dielectric layer B) and also through the respective graphene sheets. The selectivity of the first etching method for the dielectric layer A over the dielectric layer B is 50. The selectivity of the further etching method for the dielectric layer A over the dielectric layer B is 0.2. The through-holes are filled with a titanium liner by PVD and then with a tungsten metal fill by CVD. The first via of each pair extends through the respective upper graphene sheet in its non-overlapping end region and thus electrically connects to this graphene sheet. The other via of each pair extends through the respective lower graphene sheet in its non-overlapping end region and thus electrically connects to this graphene sheet. Superfluous via material on the top $SiO_2$ layer is removed by CMP. A single one of the thus obtained 5,000 modulators on the wafer is illustrated in Figure 6.

Comparative Example 3

A component precursor without through-holes is prepared as described for the Example 3. Here, however, the top layer of $SiO_2$ is omitted.

Subsequently, through-holes which extend from the top $Al_2O_3$ surface of the precursor partially through the $Al_2O_3$ to the top surfaces of the graphene sheets are prepared by photolithography.

The removal of the photoresist is done by an oxygen plasma. Each through-hole is circular in cross-section and has a diameter of 500 nm. Here, along the length of the graphene sheets, equidistantly every 1 $\mu$m a pair of 2 through-holes per graphene sheet is formed. The first through-hole of each pair extends from the top surface of the precursor to the top surface of the upper graphene sheet in the end region of the graphene sheet which does not overlap with the respective lower graphene sheet and the respective waveguide. The other through-hole of each pair extends from the top surface of the precursor to the top surface of the respective lower graphene sheet in the end region of the lower graphene sheet, which does not overlap with the respective upper graphene sheet and the respective waveguide. Atomic layer etching is used to create the through-holes in the $Al_2O_3$ layer. Acetone is used to clean the top surface of the precursor from remaining photoresist. The through-holes are used to prepare vias. For this purpose, the through-holes are filled with a titanium liner by PVD and then with a tungsten metal fill by CVD. The first via of each pair electrically connects to the top surface of the respective upper graphene sheet in its non-overlapping end region. The other via of each pair connects to the top surface of the respective lower graphene sheet in its non-overlapping end region. Superfluous via material on the top $Al_2O_3$ surface is removed by a dry etch after a lithographic contact definition.

Comparative Example 4

A component precursor without through-holes is prepared as described for the Example 3. Here, however, the top layer of $SiO_2$ is omitted.

Subsequently, through-holes which extend from the top $Al_2O_3$ surface of the precursor partially through the $Al_2O_3$ and completely through the graphene sheets are prepared by photolithography. The removal of the photoresist is done by an oxygen plasma. Each through-hole is circular in cross-section and has a diameter of 500 nm. Here, along the length of the graphene sheets, equidistantly every 1 $\mu$m a pair of 2 through-holes per graphene sheet is formed. The first through-hole of each pair extends from the top surface of the precursor through the upper graphene sheet in the end region of the upper graphene sheet, which does not overlap with the respective lower graphene sheet and the respective waveguide. The other through-hole of each pair extends from the top surface of the precursor through the respective lower graphene sheet in the end region of the lower graphene sheet, which does not overlap with the respective upper graphene sheet and the respective waveguide. Reactive ion etching is used to create the through-holes in the $Al_2O_3$ layer and the graphene. Acetone is used to clean the top surface of the precursor from remaining photoresist. The through-holes are used to prepare vias. For this purpose, the through-holes are filled with a titanium liner by PVD and then with a tungsten metal fill by CVD. The first via of each pair extends through the respective upper graphene sheet in its non-overlapping end region and thus electrically connects to this graphene sheet. The other via of each pair extends through the respective lower graphene sheet in its non-overlapping end region and thus electrically connects to this graphene sheet. Superfluous via material on the top $Al_2O_3$ surface is removed by a dry etch after a lithographic contact definition.

Some specifics of the Examples 1 to 4 and the Comparative Examples 1 to 4 as described in detail above are summarised in Table 1 for comparison.

Table 1: Summary of details of the Examples 1 to 4 and the Comparative Examples 1 to 4

| | Dielectric Layer A | Dielectric Layer B | Selectivity of First Etching Method for Dielectric Layer A over Dielectric Layer B | Selectivity of Further Etching Method for Dielectric Layer A over Dielectric Layer B | Contact of Via to Graphene | Component |
|---|---|---|---|---|---|---|
| Comparative Example 1 | / | $Al_2O_3$ | / | / | contacts top surface | photodetector |
| Comparative Example 2 | / | $Al_2O_3$ | / | / | extends through | photodetector |
| Example 1 | $SiO_2$ | $Al_2O_3$ | 50 | 0.1 | contacts top surface | photodetector |
| Example 2 | $SiO_2$ | $Al_2O_3$ | 50 | 0.2 | extends through | photodetector |
| Comparative Example 3 | / | $Al_2O_3$ | / | / | contacts top surface | modulator |
| Comparative Example 4 | / | $Al_2O_3$ | / | / | extends through | modulator |
| Example 3 | $SiO_2$ | $Al_2O_3$ | 50 | 0.1 | contacts top surface | modulator |
| Example 4 | $SiO_2$ | $Al_2O_3$ | 50 | 0.2 | extends through | modulator |

Evaluation

The responsivities of in each case 100 of the photodetectors of the Examples 1 and 2, and of the Comparative Examples 1 and 2 are tested as described above in the test methods section. In each case, the 100 photodetectors to be tested are selected from positions homogeneously distributed across the respective wafer. For each of the Examples 1 and 2, and the Comparative Examples 1 and 2, the width spanned by the responsivities of the respective 100 photodetectors is determined. Thus, for each of Examples 1 and 2, and the Comparative Examples 1 and 2, a width of the responsivities is obtained. These 4 widths are compared to one another for an evaluation of the widths of the distributions of the responsivities of the photodetectors produced in the Examples 1 and 2, and the Comparative Examples 1 and 2. The qualitative result is given in the below Table 2.

The modulation speeds of in each case 100 of the modulators of the Examples 3 and 3, and of the Comparative Examples 3 and 3 are tested as described above in the test methods section. In each case, the 100 modulators to be tested are selected from positions homogeneously distributed across the respective wafer. For each of the Examples 3 and 4, and the Comparative Examples 3 and 4, the width spanned by the modulation speeds of the respective 100 modulators is determined. Thus, for each of Examples 3 and 4, and the Comparative Examples 3 and 4, a width of the modulation speeds is obtained. These 4 widths are compared to one another for an evaluation of the widths of the distributions of the modulation speeds of the modulators produced in the Examples 3 and 4, and the Comparative Examples 3 and 4. The qualitative result is also given in the below Table 2.

The qualitative results of the comparative tests are summarised in Table 2. Therein, "++" means a more favourable result than "+" and "+" means a more favourable result than "-".

Table 2: Summary of qualitative results of the comparative tests in regard of the widths of the distributions of the responsivities of photodetectors and the widths of the distributions of the modulation speeds of modulators

|  | Width of Distribution of Responsivity | Width of Distribution of Modulation Speed |
|---|---|---|
| Comparative Example 1 | - |  |
| Comparative Example 2 | - |  |
| Example 1 | + |  |
| Example 2 | ++ |  |
| Comparative Example 3 |  | - |
| Comparative Example 4 |  | - |
| Example 3 |  | + |
| Example 4 |  | ++ |

Without wishing to be bound to this theory, based on the results of the above comparison tests the inventors believe that the reduction of the width of the distribution of the responsivity of the photodetectors and the reduction of the width of the distribution of the modulation speed of the modulators is caused by an improvement of contact resistance uniformity of the vias which electrically contact the graphene layers. This means that the variation of this contact resistance across all vias on the wafer is reduced. A narrower distribution of the responsivity and of the modulation speed allows to produce computer chips which are more reliably suitable for an operation at a predetermined speed. This is, in particular, because the slowest component of a chip determines the overall speed of the chip. In this sense, the invention allows to reduce the substandard fraction in the production of integrated circuits. Thus, the invention increases the effective production rate in the production of integrated circuits.

FIGURES

List of Figures

The figures serve to exemplify the present invention, and should not be viewed as limiting the invention. Furthermore, the figures are not drawn to scale. They show:

Figure 1          a cross-sectional scheme of a component according to the invention
Figure 2          a cross-sectional scheme of another component according to the invention
Figure 3          a cross-sectional scheme of another component according to the invention
Figure 4          a cross-sectional scheme of another component according to the invention

Figure 5      a cross-sectional scheme of another component according to the invention

Figure 6      a cross-sectional scheme of another component according to the invention

Figure 7      a flow chart of a method according to the invention

Figure 8      a cross-sectional scheme of a component precursor as provided in step A. of a method according to the invention

Figure 9      an illustration of step B. of the method of Figure 8

Figure 10      an illustration of step C. of the method of Figure 8

Figure 11      a cross-sectional scheme of a component precursor as provided in step A. of a method according to the invention

Figure 12      an illustration of step B. of the method of Figure 11

Figure 13      an illustration of step C. of the method of Figure 11

Figures 14a) to 14f)      illustrations of steps A] to F] of a method according to the invention

Figure 15      a scheme of an electronic device according to the invention

Figures 16a) to 16h)      illustrations of a method for producing a component, where neither the method nor the component is according to the invention

Figures 17a) to 17h)      illustrations of a further method for producing a component, where neither the method nor the component is according to the invention

Description of Figures

Figure 1 shows a cross-sectional scheme of a component 100 according to the invention. The component 100 comprises a layer sequence which includes a dielectric layer A 103, a dielectric layer B 104 and an optical element layer 105 superimposed on one another in the given order from a first side 101 of the component 100 to a further side 102 of the component 100. The further side 102 is opposite the first side 101. The optical element layer 105 is partially embedded in a dielectric layer C 106, which also is a layer of the layer sequence and follows the dielectric layer B 104 in a first direction 109, which runs from the first side 101 to the further side 102. The dielectric layer C 106 and the optical element layer 105 together form an embedded optical element layer 107. The layer sequence further comprises a first electrical conductor layer 108, which is fully embedded in the dielectric layer B 104 at a first distance 116 from the optical element layer 105. In a view in the first direction 109, a first region 110 of the first electrical conductor layer 108 and a first region 111 of the optical element layer 105 overlap one another. The first electrical conductor layer 108 includes a second region 114 and a third region 115, neither of which, in the view in the first direction 109, overlaps with the optical element layer 105. Further, the first electrical conductor layer 108 has a first layer surface 112, which faces away from the dielectric layer B 104. A first electrical connection 113 extends from the first layer surface 112 of the dielectric layer A 103 through the dielectric layer A 103 and partially through the dielectric layer B 104 and electrically connects to the second region 114 of the first electrical conductor layer 108. More specifically, the first electrical connection 113 connects to a surface of the first electrical conductor layer 108, which faces towards the first side 101 of the component 100. The dielectric layer A 103 is less resistant to a first etching method than the dielectric layer B 104, and the dielectric layer B 104 is less resistant to a further etching method than the dielectric layer A 103.

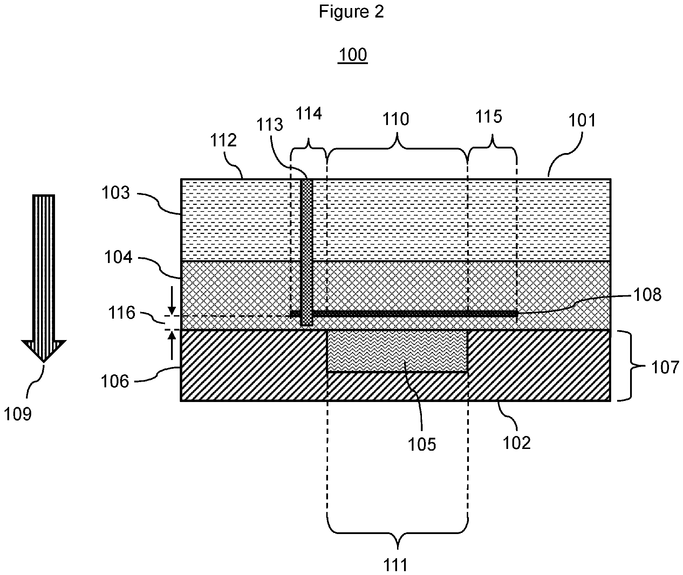

Figure 2 shows a cross-sectional scheme of another component 100 according to the invention. The component 100 of Figure 2 is identical with the component 100 in Figure 1, except that the first electrical connection 113 does not connect to a surface of the first electrical conductor layer 108, which faces towards the first side 101 of the component 100, but instead extends through the second region 114 of the first electrical conductor layer 108 in the first direction 109 and thereby electrically connects to the first electrical conductor layer 108.

Figure 3 shows a cross-sectional scheme of another component 100 according to the invention. The description of Figure 1 applies identically to Figure 3. In addition to the elements of the component 100 in Figure 1, the component 100 in Figure 3 comprises a further electrical connection 301. This further electrical connection 301 extends from the first layer surface 112 of the dielectric layer A 103 through the dielectric layer A 103 and partially through the dielectric layer B 104 and electrically connects to the third region 115 of the first electrical conductor layer 108. Similar to the first electrical connection 113, the further electrical connection 301 connects to the surface of the first electrical conductor layer 108, which faces towards the first side 101 of the component 100. Each of the first electrical connection 113 and the further electrical connection 301 is a via, which was obtained by filling a through-hole with a liner of titanium and a tungsten filling. The through-holes are circular in cross-section and each have a diameter of 500 nm. The dielectric layer A 103 consists of $SiO_2$ and has a layer thickness of 30 nm. The dielectric layer B 104 consists of $Al_2O_3$ and also has a layer thickness of 30 nm. The dielectric layer C 106 consists of $SiO_2$ and has a layer thickness of 3,500 nm. The optical element layer 105 is a waveguide which consists of SiN. The layer thickness of the optical element layer 105 is 350 nm. The first electrical conductor layer 108 is a graphene sheet, which is a single atomic carbon layer thick, i.e., has a thickness of less than 1 nm. The first distance 116 is 10 nm. The selectivity of the reactive ion etching as the first etching method for the dielectric layer A over the dielectric layer B is 50. The selectivity of the atomic layer etching as the further etching method for the dielectric layer A over the dielectric layer B is 0.1. The component 100 in Figure 3 is an opto-electronic component, more specifically a photodetector in accordance with the Example 1 above.

Figure 4 shows a cross-sectional scheme of another component 100 according to the invention. The description of Figure 2 applies identically to Figure 4. In addition to the elements of the component 100 in Figure 2, the component 100 in Figure 4 comprises a further electrical connection 301. This further electrical connection 301 extends from the first layer surface 112 of the dielectric layer A 103 through the dielectric layer A 103, partially through the dielectric layer B 104 and through the third region 115 of the first electrical conductor layer 108 and thereby electrically connects to the first electrical conductor layer 108. Each of the first electrical connection 113 and the further electrical connection 301 is a via, which was obtained by filling a through-hole with a liner of titanium and a tungsten filling. The through-holes are circular in cross-section and each have a diameter of 500 nm. The dielectric layer A 103 consists of $SiO_2$ and has a layer thickness of 30 nm. The dielectric layer B 104 consists of $Al_2O_3$ and also has a layer thickness of 30 nm. The dielectric layer C 106 consists of $SiO_2$ and has a layer thickness of 3,500 nm. The optical element layer 105 is a waveguide which consists of SiN. The layer thickness of the optical element layer 105 is 350 nm. The first electrical conductor layer 108 is a graphene sheet, which is a single atomic carbon layer thick, i.e., has a thickness of less than 1 nm. The first distance 116 is 10 nm. The selectivity of the reactive ion etching as the first etching method for the dielectric layer A over the dielectric layer B is 50. The selectivity of the reactive ion etching as the further etching method for the dielectric layer A over the dielectric layer B is 0.2. The component 100 in Figure 4 is an opto-electronic component, more specifically a photodetector in accordance with the Example 2 above.

Figure 5 shows a cross-sectional scheme of another component 100 according to the invention. The description of Figure 1 applies identically to Figure 5 with the exception that the first electrical conductor layer 108 of the component in Figure 5 does not include the third region 115. Further, the layer sequence of the component 100 in Figure 5 additionally comprises a further electrical conductor layer 501. This further electrical conductor layer 501 is fully embedded in the dielectric layer B 104 at a further distance 504 from the optical element layer 105. Here, the first distance 116 is 10 nm and the further distance 504 is about 20 nm. In the view in the first direction 109, the first region 110 of the first electrical conductor layer 108, a first region 502 of the further electrical conductor layer 501 and the first region 111 of the optical element layer 105 overlap one another. Here, the first region 110 of the first electrical conductor layer 108 overlaps with the optical element layer 105 over an entire surface of the optical element layer 105 which faces towards the first side 101 of the component 100. Still in the view in the first direction 109, the first region 502 of the further electrical conductor layer 501 also overlaps with the optical element layer 105 over the entire surface of the optical element layer 105 which faces towards the first side 101 of the component 100. Still in the view in the first direction 109, the second region 114 of the first electrical conductor layer 108 neither overlaps with the further electrical conductor layer 501 nor with the optical element layer 105. The further electrical conductor layer 501 also includes a second region 503. Again in the view in the first direction 109, the second region 503 of the further electrical conductor layer 501 neither overlaps with the first electrical conductor layer 108 nor with the optical element layer 105. The component 100 in Figure 5 additionally comprises a further electrical connection 301. This further electrical connection 301 extends from the first layer surface 112 of the dielectric layer A 103 through the dielectric layer A 103, partially through the dielectric layer B 104 and electrically connects to the second region 503 of the further electrical conductor layer 501. The further electrical connection 301 connects to a surface of the further electrical conductor layer 501, which faces towards the first side 101 of the component 100. Each of the first electrical connection 113 and the further electrical connection 301 is a via, which was obtained by filling a through-hole with a liner of titanium and a tungsten filling. The through-holes are circular in cross-section and each have a diameter of 500 nm. The dielectric layer A 103 consists of $SiO_2$ and has a layer thickness of 30 nm. The dielectric layer B 104 consists of $Al_2O_3$ and has a layer thickness of about 40 nm. The dielectric layer C 106 consists of $SiO_2$ and has a layer thickness of 3,500 nm. The optical element layer 105 is a waveguide which consists of SiN. The layer thickness of the optical element layer 105 is 350 nm. Each of the first electrical conductor layer 108 and the further electrical conductor layer 501 is a graphene sheet, which is a single atomic carbon layer thick, i.e., has a thickness of less than 1 nm. The selectivity of the reactive ion etching as the first etching method for the dielectric layer A over the dielectric layer B is 50. The selectivity of the atomic layer etching as the further etching method for the dielectric layer A over the dielectric layer B is 0.1. The component 100 in Figure 5 is an opto-electronic component, more specifically a modulator in accordance with the Example 3 above.

Figure 6 shows a cross-sectional scheme of another component 100 according to the invention. The component 100 of Figure 6 is identical with the component 100 in Figure 5, except that the first electrical connection 113 does not connect to a surface of the first electrical conductor layer 108, which faces towards the first side 101 of the component 100, and the further electrical connection 301, also does not connect to a surface of the further electrical conductor layer 301, which faces towards the first side 101 of the component 100. Rather, the first electrical conductor layer 108 extends through the second region 114 of the first electrical conductor layer 108 in the first direction 109 and thereby electrically connects to the first electrical conductor layer 108. The further electrical conductor layer 301 extends through the second region 503 of the further electrical conductor layer 501 in the first direction 109 and thereby electrically connects to the further electrical conductor layer 501. The component 100 in Figure 6 is an opto-electronic component, more specifically a modulator in accordance with the Example 4 above. Here, the selectivity of the reactive ion etching as the first etching method for the dielectric layer A over the dielectric layer B is 50. The selectivity of reactive ion etching as the further etching method for the dielectric layer A over the dielectric layer B is 0.2.

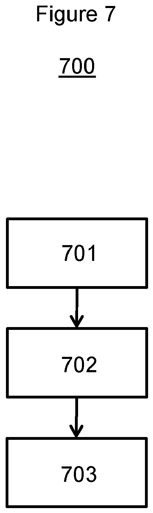

Figure 7 shows a flow chart of a method 700 according to the invention. In a method step A. 701, a component precursor 800 is provided. This component precursor 800 comprises a layer sequence, including a dielectric layer A 103, a dielectric layer B 104 and an optical element layer 105 superimposed on one another in the given order from a first side 801 of the component precursor 800 to a further side 802 of the component precursor 800, which is opposite to the first side 801. The dielectric layer A 103 is less resistant to a first etching method than the dielectric layer B 104, and the dielectric layer B 104 is less resistant to a further etching method than the dielectric layer A 103. The layer sequence further comprises a first electrical conductor layer 108. In a view in a first direction 109, which runs from the first side 801 to the further side 802, a first region 110 of the first electrical conductor layer 108 and a first region 111 of the optical element layer 105 overlap one another. A first layer surface 112 of the dielectric layer A 103 faces away from the dielectric layer B 104. A first through-hole 803 extends from the first layer surface 112 of the dielectric layer A 103 through the dielectric layer A 103. In a method step B. 702, the first through-hole 803 is extended at least to the first electrical conductor layer 108 by the further etching method. In a method step C. 703, the first through-hole 803 is filled or coated with a first electrically conductive material 1001 to obtain a first electrical connection 113, which extends from the first layer surface 112 of the dielectric layer A 103 through the dielectric layer A 103 and partially through the dielectric layer B 104 and electrically connects to the first electrical conductor layer 108.

Figure 8 shows a cross-sectional scheme of a component precursor 800 as provided in step A. 701 of a method 700 according to the invention. The component precursor 800 is a precursor of the component 100 in Figure 1. Accordingly, the component precursor 800 comprises a layer sequence, including the dielectric layer A 103, the dielectric layer B 104 with first electrical conductor layer 108 embedded in it, and the embedded optical element layer 107, formed by the dielectric layer C 106 and the optical element layer 105. The dielectric layer A 103, the dielectric layer B 104 and the embedded optical element layer 107 are superimposed on one another in the given order from a first side 801 of the component precursor 800 to a further side 802 of the component precursor 800, which is opposite to the first side 801. A first through-hole 803 extends from the first layer surface 112 of the dielectric layer A 103 through the dielectric layer A 103.

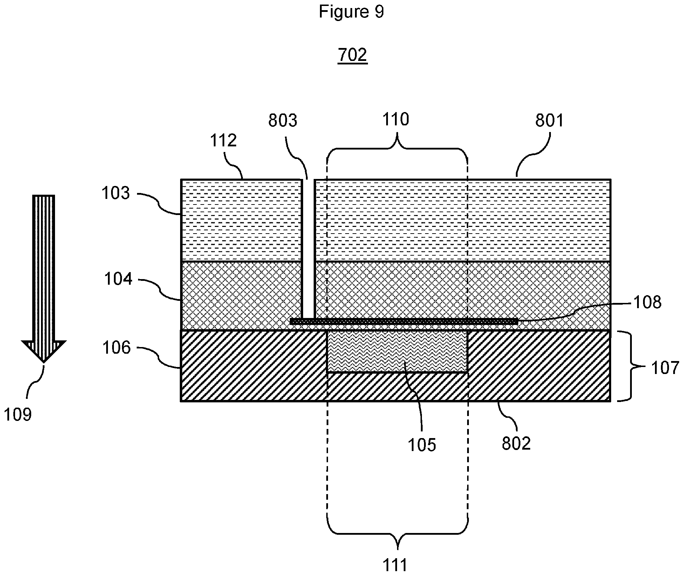

Figure 9 shows an illustration of step B. 702 of the method 700 as referred to in regard of Figure 8. In the method step B. 702, the first through-hole 803 was extended partially through the dielectric layer B 104 to a surface of the first electrical conductor layer 108, which faces the first side 801. For this purpose, the further etching method was used.

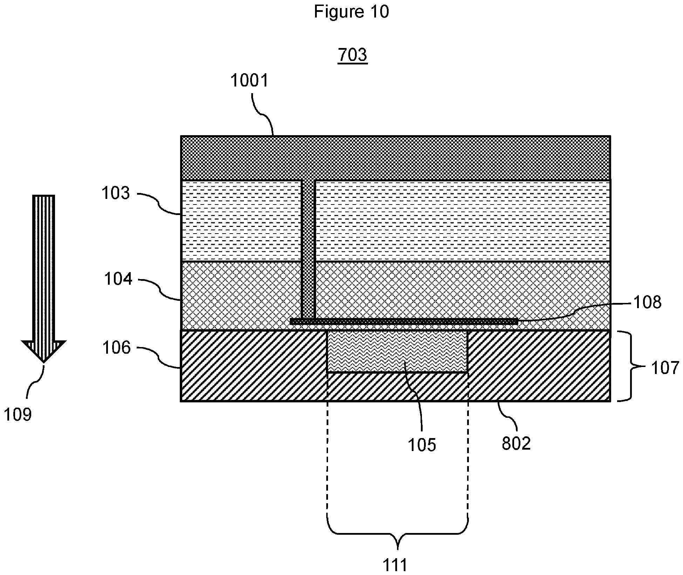

Figure 10 shows an illustration of step C. 703 of the method 700 as referred to in regard of Figures 8 and 9. In the method step C. 703, the first through-hole 803 was filled with a first electrically conductive material 1001. Removing superfluous electrically conductive material on the first surface 112 of the dielectric layer A 103 results in the component 100 of Figure 1 with the first electrical connection 113, which extends from the first layer surface 112 of the dielectric layer A 103 through the dielectric layer A 103 and partially through the dielectric layer B 104 and electrically connects to the surface of the first electrical conductor layer 108, which faces the first side 801.

Figure 11 shows a cross-sectional scheme of a component precursor 800 as provided in step A. 701 of a method 700 according to the invention. The component precursor 800 is a precursor of the component 100 in Figure 2. Accordingly, the component precursor 800 comprises a layer sequence, including the dielectric layer A 103, the dielectric layer B 104 with first electrical conductor layer 108 embedded in it, and the embedded optical element layer 107, formed by the dielectric layer C 106 and the optical element layer 105. The dielectric layer A 103, the dielectric layer B 104 and the embedded optical element layer 107 are superimposed on one another in the given order from a first side 801 of the component precursor 800 to a further side 802 of the component precursor 800, which is opposite to the first side 801. A first through-hole 803 extends from the first layer surface 112 of the dielectric layer A 103 through the dielectric layer A 103.

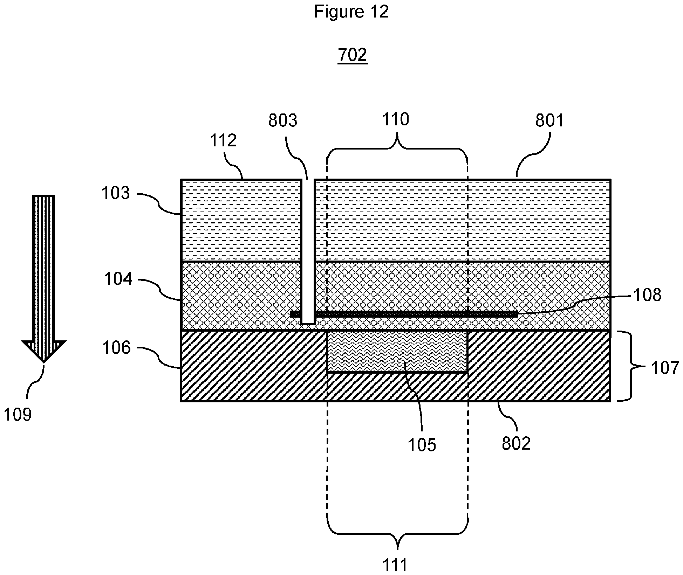

Figure 12 shows an illustration of step B. 702 of the method 700 as referred to in regard of Figure 11. In the method step B. 702, the first through-hole 803 was extended partially through the dielectric layer B 104 and through the first electrical conductor layer 108. For this purpose, the further etching method was used.

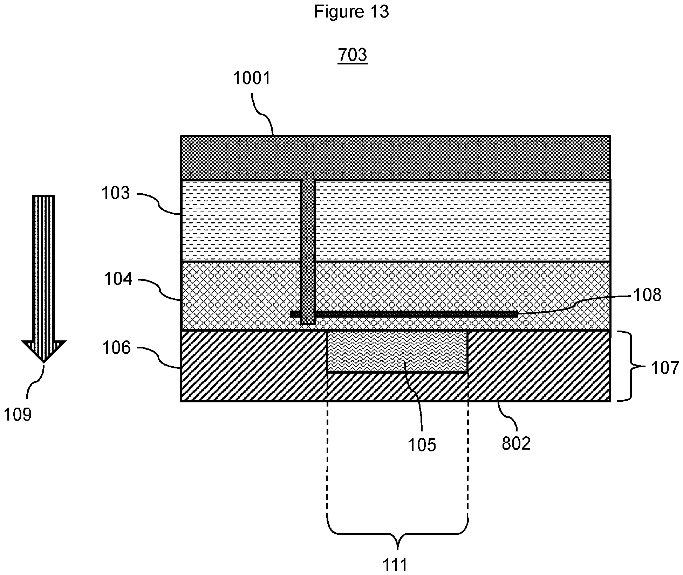

Figure 13 shows an illustration of step C. 703 of the method 700 as referred to in regard of Figures 11 and 12. In the method step C. 703, the first through-hole 803 was filled with a first electrically conductive material 1001. Removing superfluous electrically conductive material on the first surface 112 of the dielectric layer A 103 results in the component 100 of Figure 2 with the first electrical connection 113, which extends from the first layer surface 112 of the dielectric layer A 103 through the dielectric layer A 103, partially through the dielectric layer B 104 and through the first electrical conductor layer 108 and thereby electrically connects to the first electrical conductor layer 108.

Figure 14a) to 14f) show illustrations of steps A] 1401 to F] 1405 of a method 700 according to the invention. This method 700 may be the method 700 as referred to in regard of Figures 8 to 10 or the method 700 as referred to in regard of Figures 11 to 13. Figure 14a) shows the component precursor 800 from Figure 8 or 11, in each case without the first through-hole 803. Figure 14b) shows the result of method step A] 1401. A photoresist layer 1406 was applied to the dielectric layer A 103 on a side of the dielectric layer A 103, which is opposite the dielectric layer B 104. Figure 14c) illustrates method step B] 1402. A mask 1407 with an opening 1408 was placed on the photoresist layer 1406. Through the opening 1408, a region of the photoresist layer 1406 is irradiated with ultraviolet radiation 1409. Figure 14d) shows the result of method step C] 1403. The photoresist layer 1406 was developed. This means that the region of the photoresist layer 1406 was removed. Thereby a first auxiliary through-hole 1410 in the photoresist layer 1406 was obtained. Figure 14e) illustrates method step D] 1404. A first etchant 1411 is introduced into the first auxiliary through-hole 1410 and the first through-hole 803 is formed in the dielectric layer A 103. Figure 14f) shows the result of method step E] 1405. The photoresist layer 1406 was removed, thereby obtaining the component precursor 800 in Figure 8 or 11.

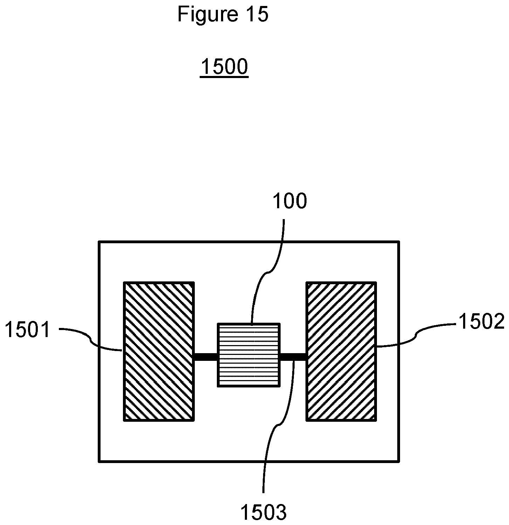

Figure 15 shows a scheme of an electronic device 1500 according to the invention. The electronic device 1500 comprises the component 100 of Figure 4, a first integrated circuit 1501 and a further integrated circuit 1502. The first integrated circuit 1501 and the further integrated circuit 1502 are arranged and adapted to communicate with one another via a waveguide 1503 and the component 100.

Figure 16a) to 16f) show illustrations of a method for producing a component, where neither the method nor the component is according to the invention. The component precursor shown in cross-section in Figure 16a) is provided. This component precursor comprises a layer sequence which includes a layer of $Al_2O_3$ 1601 and a layer of $SiO_2$ 1602 superimposed on one another. A waveguide of SiN is partially embedded in the layer of $SiO_2$ 1602. The layer sequence further comprises a graphene sheet 1604, which is fully embedded in the layer of $Al_2O_3$ 1601. Figure 16b) shows that a photoresist layer 1406 was applied to the layer of $Al_2O_3$ 1601. In Figure 16c), a mask 1407 with an opening 1408 was placed on the photoresist layer 1406. Through the opening 1408, a region of the photoresist layer 1406 is irradiated with ultraviolet radiation 1409. The photoresist layer 1406 is developed, i.e., the region of the photoresist layer 1406 is removed. Thereby, a through-hole 1605 in photoresist is obtained as illustrated in Figure 16d).

As illustrated in Figure 16e), an etchant 1606 is introduced into the through-hole 1605 to etch a through-hole 1607 into the layer of $Al_2O_3$ 1601. This through-hole 1607 extends to a surface of the graphene sheet 1604 which faces upwards in Figure 16e). The remainders of the photoresist layer 1406 are removed by an oxygen plasma and rinsing with acetone to obtain the situation in Figure 16f). The through-hole 1607 is filled with a titanium liner by PVD and then with a metal fill of tungsten 1608 by CVD. Superfluous tungsten 1608 on the layer of $Al_2O_3$ 1601 is removed by by a dry etch after a lithographic contact definition to obtain the component in Figure 16h) with via 1609.

Figure 17a) to 17h) show illustrations of a further method for producing a component, where neither the method nor the component is according to the invention. This method is identical with the method illustrated in Figures 16a) to 16h), except that the through-hole 1607 is not etched to stop at the surface of the graphene sheet 1604 which faces upwards, but is etched through the graphene sheet 1604 as shown in Figure 17e). Accordingly, in Figure 17h), the via 1609 also extends through the graphene sheet 1604.

REFERENCE LIST

| | |
|---|---|
| **100** | component according to the invention |
| 101 | first side of the component |
| 102 | further side of the component |
| 103 | dielectric layer A |
| 104 | dielectric layer B |
| 105 | optical element layer |
| 106 | dielectric layer C |
| 107 | embedded optical element layer |
| 108 | first electrical conductor layer |
| 109 | first direction |
| 110 | first region of the first electrical conductor layer |
| 111 | first region of the optical element layer |
| 112 | first layer surface of the dielectric layer A |
| 113 | first electrical connection |
| 114 | second region of the first electrical conductor layer |
| 115 | third region of the first electrical conductor layer |
| 116 | first distance |
| 301 | further electrical connection |
| 501 | further electrical conductor layer |
| 502 | first region of the further electrical conductor layer |
| 503 | second region of the further electrical conductor layer |
| 504 | further distance |
| 700 | method according to the invention |
| 701 | method step A. |

702 method step B.
703 method step C.
800 component precursor
**801** first side of the component precursor
802 further side of the component precursor
803 first through-hole
**1001** first electrically conductive material
**1401** method step A]
**1402** method step B]
**1403** method step C]
**1404** method step D]
**1405** method step E]
**1406** photoresist layer
**1407** mask
**1408** opening
**1409** ultraviolet radiation
**1410** first auxiliary through-hole
**1411** first etchant
**1500** electronic device according to the invention
**1501** first integrated circuit
**1502** further integrated circuit
**1503** waveguide
**1601** layer of $Al_2O_3$
**1602** layer of $SiO_{23}$
**1603** waveguide of SiN
**1604** graphene sheet
**1605** through-hole in photoresist
**1606** etchant
1607 through-hole in layer of $SiO_2$
**1608** tungsten
**1609** via

**Claims**

1. A component (100), comprising a layer sequence, including at least the following layers superimposed on one another in the given order from a first side (101) of the component (100) to a further side (102) of the component (100), which is opposite to the first side (101):

    a. a dielectric layer A (103),
    b. a dielectric layer B (104), and
    c. an optical element layer (105);
    wherein the layer sequence further comprises a first electrical conductor layer (108); wherein, in a view in a first direction (109), which runs from the first side (101) to the further side (102), at least a first region (110) of the first electrical conductor layer (108) and at least a first region (111) of the optical element layer (105) overlap one another; wherein a first layer surface (112) of the dielectric layer A (103) faces away from the dielectric layer B (104);
    wherein a first electrical connection (113) extends from the first layer surface (112) of the dielectric layer A (103) through the dielectric layer A (103) and at least partially through the dielectric layer B (104) and electrically connects to the first electrical conductor layer (108);
    wherein the dielectric layer A (103) is less resistant to a first etching method than the dielectric layer B (104), and the dielectric layer B (104) is less resistant to a further etching method than the dielectric layer A (103).

2. The component (100) according to claim 1, wherein at last one of the following applies:

    a| a selectivity of the first etching method for the dielectric layer A (103) over the dielectric layer B (104) is more than 1;
    b| a selectivity of the first etching method for the dielectric layer B (104) over the dielectric layer A (103) is less than 1;

c| a selectivity of the further etching method for the dielectric layer A (103) over the dielectric layer B (104) is less than 1;
d| a selectivity of the further etching method for the dielectric layer B (104) over the dielectric layer A (103) is more than 1.

3. The component (100) according to claim 1 or 2, wherein the first electrical conductor layer (108) has a layer thickness of less than 1 $\mu$m.

4. The component (100) according to any of the preceding claims, wherein a further electrical connection (301) extends from the first layer surface (112) of the dielectric layer A (103) through the dielectric layer A (103) and at least partially through the dielectric layer B (104) and electrically connects to the first electrical conductor layer (108).

5. The component (100) according to any of the preceding claims, wherein the layer sequence further comprises a further electrical conductor layer (501);

wherein, in the view in the first direction (109) at least the first region (110) of the first electrical conductor layer (108), at least a first region (502) of the further electrical conductor layer (501) and at least the first region (111) of the optical element layer (105) overlap one another;
wherein a further electrical connection (301) extends from the first layer surface (112) of the dielectric layer A (103) through the dielectric layer A (103) and at least partially through the dielectric layer B (104) and electrically connects to the further electrical conductor layer (501).

6. The component (100) according to any of the preceding claims, wherein the first electrical conductor layer (108) is at least partially embedded in the dielectric layer B (104) at a first distance (116) from the optical element layer (105).

7. The component (100) according to claim 6, wherein the further electrical conductor layer (501) is at least partially embedded in the dielectric layer B (104) at a further distance (504) from the optical element layer (105);
wherein the first distance (116) is more than the further distance (504).

8. The component (100) according to any of the preceding claims, wherein the optical element layer (105) is at least partially embedded in a dielectric layer C (106);
wherein the dielectric layer C (106) is a layer of the layer sequence and follows the dielectric layer B (104) in the first direction (109).

9. The component (100) according to any of the preceding claims, wherein at least one of the following applies:

a] the first electrical conductor layer (108) includes a second region (114), which, in the view in the first direction (109), does not overlap with the further electrical conductor layer (501), or does not overlap with the optical element layer (105), or does not overlap with any of both;
b] the first electrical conductor layer (108) includes a third region (115), which, in the view in the first direction (109), does not overlap with the further electrical conductor layer (501), or does not overlap with the optical element layer (105), or does not overlap with any of both;
c] in the view in the first direction (109) the first region (110) of the first electrical conductor layer (108) overlaps with the optical element layer (105) over an entire surface of the optical element layer (105) which faces towards the first side (101) of the component (100);
d] the further electrical conductor layer (501) includes a second region (503), which, in the view in the first direction (109), does not overlap with the first electrical conductor layer (108), or does not overlap with the optical element layer (105), or does not overlap with any of both;
e] in the view in the first direction (109) the first region (502) of the further electrical conductor layer (501) overlaps with the optical element layer (105) over the entire surface of the optical element layer (105) which faces towards the first side (101) of the component (100).

10. The component (100) according to claim 9, wherein one or two of the following applies:

a# the first electrical connection (113) electrically connects to the second region (114) of the first electrical conductor layer (108);
b# the further electrical connection (301) electrically connects to the third region (115) of the first electrical conductor layer (108);

c# the further electrical (301) connection electrically connects to the second region (503) of the further electrical conductor layer (501).

11. The component (100) according to any of the preceding claims, wherein one or two of the following applies:

   a~ the first electrical connection (113) connects to a surface of the first electrical conductor layer (108), which faces towards the first side (101) of the component (100);
   b~ the further electrical connection (301) connects to the surface of the first electrical conductor layer (108), which faces towards the first side (101) of the component (100);
   c~ the further electrical connection (301) connects to a surface of the further electrical conductor layer (501), which faces towards the first side (101) of the component (100);
   d~ the first electrical connection (113) extends through the first electrical conductor layer (108) in the first direction (109);
   e~ the further electrical connection (301) extends through the first electrical conductor layer (108) in the first direction (109);
   f~ the further electrical connection (301) extends through the further electrical conductor layer (501) in the first direction (109).

12. The component (100) according to any of the preceding claims, wherein the first electrical conductor layer (108), or the further electrical conductor layer (501), or each of both is a graphene sheet.

13. The component (100) according to any of the preceding claims, wherein the optical element layer (105) is one selected from the group consisting of a waveguide, a grating, a prism, a lens, and a coupler, or a combination of at least two thereof

14. A method (700) comprising as method steps in the following order:

   A. providing a component precursor (800), comprising a layer sequence, including at least the following layers superimposed on one another in the given order from a first side (801) of the component precursor (800) to a further side (802) of the component precursor (800), which is opposite to the first side (801):

      I. a dielectric layer A (103),
      II. a dielectric layer B (104), and
      III. an optical element layer (105);
      wherein the dielectric layer A (103) is less resistant to a first etching method than the dielectric layer B (104), and the dielectric layer B (104) is less resistant to a further etching method than the dielectric layer A (103);
      wherein the layer sequence further comprises a first electrical conductor layer (108);
      wherein, in a view in a first direction (109), which runs from the first side (801) to the further side (802), at least a first region (110) of the first electrical conductor layer (108) and at least a first region (111) of the optical element layer (105) overlap one another;
      wherein a first layer surface (112) of the dielectric layer A (103) faces away from the dielectric layer B (104);
      wherein a first through-hole (803) extends from the first layer surface (112) of the dielectric layer A (103) through the dielectric layer A (103);

   B. extending the first through-hole (803) at least to the first electrical conductor layer (108) by the further etching method; and
   C. introducing a first electrically conductive material (1001) into the first through-hole (803) to obtain a first electrical connection (113), which extends from the first layer surface (112) of the dielectric layer A (103) through the dielectric layer A (103) and at least partially through the dielectric layer B (104) and electrically connects to the first electrical conductor layer (108).

15. The method (700) according to claim 14, wherein the method step A. includes forming the first through-hole (803) in dielectric layer A (103) by the first etching method.

16. An electronic device (1500), comprising the component (100) according to any of the claims 1 to 13, or a component (100) obtainable by the method (700) according to claim 14 or 15.

17. A use of the component (100) according to any of the claims 1 to 13, or a component (100) obtainable by the method (700) according to claim 14 or 15 for producing an electronic device (1500).

18. A use of the component (100) according to any of the claims 1 to 13, or a component (100) obtainable by the method according to claim 14 or 15 for

a_establishing a communication between a first integrated circuit (1501) and a further integrated circuit (1501);
b_ establishing a communication between a first part of an integrated circuit and a further part of the integrated circuit; or
c_injecting an optical vector in an optical network and/or reading out an optical vector from an optical network.

Figure 1

100

Figure 2

<u>100</u>

Figure 3

100

Figure 4

100

Figure 5

100

Figure 6

<u>100</u>

Figure 7

700

Figure 8

<u>701, 800</u>

Figure 9

702

Figure 10

<u>703</u>

Figure 11

701, 800

Figure 12

702

Figure 13

<u>703</u>

1001

103

104

108

106

109

105

802

107

111

Figure 14a)

Figure 14b)

Figure 14c)

Figure 14d)

Figure 14e)

Figure 14f)

1404

1405

1411

803

Figure 15

1500

Figure 16a)

Figure 16b)

Figure 16c)

Figure 16d)

Figure 16e)

Figure 16f)

Figure 16g)

Figure 16h)

Figure 17a)

Figure 17b)

1601 ⎯ 1604

1602 ⎯

1603

1406 ⎯

Figure 17c)

Figure 17d)

1409

1408

1407 ⎯

1605

Figure 17e)

Figure 17f)

1606

1607

Figure 17g)

Figure 17h)

1609

1608

Europäisches
Patentamt

European
Patent Office

Office européen
des brevets

# EUROPEAN SEARCH REPORT

**Application Number**

EP 23 20 0214

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/123602 A1 (SCHALL DANIEL [DE]) 20 April 2023 (2023-04-20) * figures 2, 3, 6, 7, 8, 9, 10, 11 * * paragraphs [0006], [0191], [0194], [0196], [0206] – [0208], [0210] * ----- | 1-18 | INV. H01L31/0232 ADD. G02B6/12 G02F1/025 G02F1/035 |

**TECHNICAL FIELDS SEARCHED (IPC)**

H01L
G02B
G02F

The present search report has been drawn up for all claims

| Place of search | Date of completion of the search | Examiner |
|---|---|---|
| The Hague | 21 February 2024 | Topak, Eray |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 20 0214**

This annex lists the patent family members relating to the patent documents cited in the above-mentioned European search report.
The members are as contained in the European Patent Office EDP file on
The European Patent Office is in no way liable for these particulars which are merely given for the purpose of information.

**21-02-2024**

| Patent document cited in search report | Publication date | Patent family member(s) | Publication date |
|---|---|---|---|
| US 2023123602 A1 | 20-04-2023 | CA 3169253 A1 | 05-08-2021 |
| | | CN 115039003 A | 09-09-2022 |
| | | DE 102020102534 A1 | 05-08-2021 |
| | | EP 4097520 A1 | 07-12-2022 |
| | | JP 2023512099 A | 23-03-2023 |
| | | KR 20220126734 A | 16-09-2022 |
| | | US 2023123602 A1 | 20-04-2023 |
| | | WO 2021151594 A1 | 05-08-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LEWANDOWSKI** ; **GU**. A Multireflect-Thru Method of Vector Network Analyzer Calibration. *IEEE Transactions on Microwave Theory and Techniques*, 2017, vol. 65 (3), 905
- **F. HOFER et al.** Fundamentals of electron energy-loss spectroscopy. *EMAS 2015 Workshop, IOP Conf. Series: Materials Science and Engineering*, 2016, vol. 109, 012007

- **ANDREA C. FERRARI** ; **DENIS M. BASKO**. Raman spectroscopy as a versatile tool for studying the properties of graphene. *nature nanotechnology*, 04 April 2013, vol. 8 (4)